(19) Europäisches Patentamt
European Patent Office
Office européen des brevets

(11) **EP 3 435 102 A1**

(12) **EUROPÄISCHE PATENTANMELDUNG**

(43) Veröffentlichungstag:
**30.01.2019  Patentblatt 2019/05**

(51) Int Cl.:
**G01R 31/36** (2019.01)    *G06F 17/18* (2006.01)
**H03H 17/02** (2006.01)

(21) Anmeldenummer: **17183316.3**

(22) Anmeldetag: **26.07.2017**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **INVENOX GmbH**
**85748 Garching (DE)**

(72) Erfinder: **WALDER, Georg**
**81679 München (DE)**

(74) Vertreter: **Isarpatent**
**Patent- und Rechtsanwälte Behnisch Barth Charles**
**Hassa Peckmann & Partner mbB**
**Friedrichstrasse 31**
**80801 München (DE)**

(54) **VERFAHREN UND VORRICHTUNG ZUR DETEKTION VON BATTERIEZELLENZUSTÄNDEN UND BATTERIEZELLENPARAMETERN**

(57)      Vorrichtung (1) und Verfahren zur Detektion von Batteriezellenzuständen, BZZ, und/oder Batteriezellenparametern, BZP, mindestens einer Batteriezelle (BZ) mit einem dualen Kalman-Filter (2), der einen Zustandsschätzer (2A) zur Schätzung von Batteriezellenzuständen, BZZ, und einen Parameterschätzer (2B) zur Schätzung von Batteriezellenparametern, BZP, aufweist, und mit einer Ermittlungseinheit (3), die geeignet ist, Rauschanteile (n, v) des Zustandsschätzers (2A) und des Parameterschätzers (2B) anhand eines gespeicherten charakteristischen Parameterverhaltens der Batteriezelle (BZ) zu ermitteln, wobei die Batteriezellenzustände, BZZ, und die Batteriezellenparameter, BZP, an ein vorgegebenes Batteriemodell (BM) der Batteriezelle (BZ) durch das duale Kalman-Filter (2) auf Basis der durch die Ermittlungseinheit ermittelten Rauschanteile (n, v) automatisch anpassbar sind.

Fig. 3

EP 3 435 102 A1

**Beschreibung**

Die Erfindung betrifft ein Verfahren und eine Vorrichtung zum Detektieren von Batteriezellenzuständen und von Batteriezellenparametern mindestens einer Batteriezelle.

Batterie-Management-Systeme dienen der Sicherstellung einer optimalen Nutzung einer in einem Energiespeicher bzw. Batterie gespeicherten Energie. Batterie-Management-Systeme dienen weiterhin vor allem dem Schutz einer Batterie vor Beschädigungen, beispielsweise aufgrund eines zu schnell vorgenommenen Ladevorganges. Batterie-Management-Systeme umfassen elektronische Regelschaltungen, die Ladung und Entladung von Akkumulatoren bzw. Batterien überwachen und regeln. Batterie-Management-Systeme können beispielsweise bei Elektrofahrzeugen oder Photovoltaikanlagen vorgesehen werden, um die elektrischen Energiespeicher optimal zu nutzen und vor Beschädigungen zu schützen. Herkömmliche Batterie-Management-Systeme setzen teilweise Kalman-Filter zur Zustandsschätzung von Batterien ein. Eine Batterie weist mindestens eine Batteriezelle auf. Dabei wird das Verhalten der Batteriezelle mithilfe eines Batteriemodelles nachgebildet. Das dynamische Verhalten einer Batterie kann mithilfe eines elektrischen Ersatzschaltbildes nachgebildet werden. Weiterhin kann die Modellierung der Batterie beispielsweise über ein sogenanntes Blackbox-Modell erfolgen.

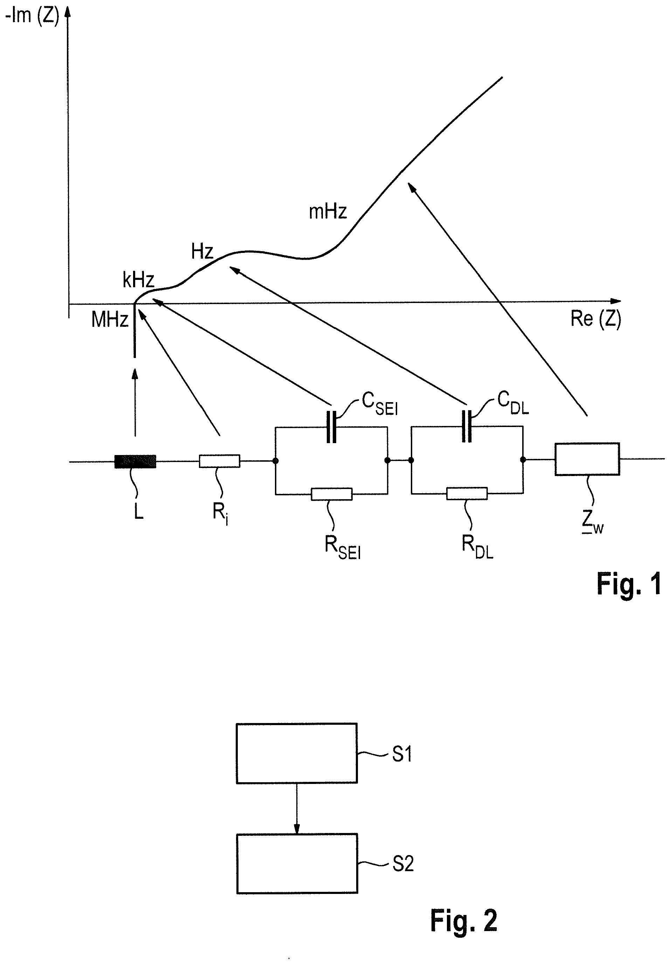

Fig. 1 zeigt beispielsweise ein elektrisches Ersatzschaltbild einer Lithium-Ionen-Batteriezelle und einen zugehörigen Impedanzverlauf der in dem Ersatzschaltkreis enthaltenen Baukomponenten. Der in Fig. 1 dargestellte Ersatzschaltkreis bildet somit ein Batteriemodell der Batteriezelle, mit dem das Verhalten der Batteriezelle, beispielsweise ein Frequenzverhalten, ermittelt werden kann. In dem Batteriemodell gemäß Fig. 1 sind eine Induktivität L, ein Innenwiderstand $R_i$, eine Kapazität wie eine Diffusionskapazität zwischen zwei Anschlussklemmen verschaltet. Mit variierender Frequenz ändert sich der Imaginärteil und der Realteil der komplexen Impedanz Z des Ersatzschaltkreises bzw. Batteriemodells. Da die Anzahl an Komponenten in dem Ersatzschaltkreis auch die Anzahl der notwendigen Zustände des Systems vorgibt, werden bei herkömmlichen Batteriemodellen Vereinfachungen vorgenommen. Beispielsweise werden Ersatzschaltkreise verwendet, die nur den Innenwiderstand $R_i$, eine Kombination des Innenwiderstandes $R_i$ mit einem zusammengefassten RC-Glied oder einen Innenwiderstand $R_i$ mit einem ersten RC-Glied zur Modellierung des kHz-Frequenzbereichs und einem weiteren RC-Glied zur Modellierung des Hz-Frequenzbereichs umfassen.

Herkömmliche Batteriemodelle BM erlauben nur die Schätzung von Zuständen, beispielsweise eines Ladezustandes SoC einer Batteriezelle. Dabei werden Batteriezellenparameter, beispielsweise ein Innenwiderstand oder eine Batteriezellenkapazität, weitgehend als konstant angenommen, sodass keine dynamischen Veränderungen der Batteriezellenparameter berücksichtigt werden. Demzufolge sind bei herkömmlichen Ansätzen die Batteriezellenparameter der Batteriezelle nicht beobachtbar. Beispielsweise ist bei der herkömmlichen Vorgehensweise die Veränderung eines Batteriezellenparameters, z.B. des Innenwiderstandes der Batteriezelle, nicht erfassbar oder bedürfen einer aufwendigen Vermessung. Ein Grund hierfür liegt vor allem im nicht deterministischen Verhalten des adaptiven Systems. Dies kann dazu führen, dass das herkömmliche Batterie-Management-System nach unbestimmter Zeit divergiert und instabil wird.

Es ist daher eine Aufgabe der vorliegenden Erfindung, ein Verfahren und eine Vorrichtung zu schaffen, die es erlauben, Batteriezellenzustände und Batteriezellenparameter präziser zu erfassen.

Diese Aufgabe wird erfindungsgemäß durch ein Verfahren mit den in Patentanspruch 1 angegebenen Merkmalen gelöst.

Die Erfindung schafft demnach gemäß einem ersten Aspekt ein Verfahren zum Detektieren von Batteriezellenzuständen und von Batteriezellenparametern mindestens einer Batteriezelle mit den folgenden Schritten:

Ermitteln von Rauschanteilen eines Zustandsschätzers eines dualen Kalman-Filters und Ermitteln von Rauschanteilen eines Parameterschätzers des dualen Kalman-Filters anhand eines charakteristischen Parameterverhaltens der Batteriezelle bezüglich mindestens einer Batteriezellenkenngröße der Batteriezelle und

Anpassen der Batteriezellenzustände und der Batteriezellenparameter an ein vorgegebenes Batteriemodell der Batteriezelle durch das duale Kalman-Filter auf Basis der ermittelten Rauschanteile.

Mit dem erfindungsgemäßen Verfahren werden somit ermittelte Rauschanteile zur Anpassung bzw. Schätzung der Batteriezellenzustände und der Batteriezellenparameter herangezogen. Dies erlaubt eine dynamische und adaptive Schätzung der Batteriezellenzustände und/oder der Batteriezellenparameter. Das duale Kalman-Filter wird somit anhand messbarer Rauschkomponenten getuned bzw. eingestellt.

Bei einer möglichen Ausführungsform des erfindungsgemäßen Verfahrens umfassen die Batteriezellenzustände einen Ladezustand der Batteriezelle und/oder dynamische Batteriezellenzustände, insbesondere eine Diffusionsspannung der Batteriezelle.

Bei einer möglichen Ausführungsform des erfindungsgemäßen Verfahrens weisen die Batteriezellenparameter einen Innenwiderstand der Batteriezelle, eine Nennkapazität der Batteriezelle und/oder resistive Dynamikkomponenten auf, insbesondere einen Diffusionswiderstand der Batteriezelle und/oder kapazitive Dynamikkomponenten, insbesondere eine Diffusionskapazität der Batteriezelle.

Bei einer weiteren möglichen Ausführungsform des erfindungsgemäßen Verfahrens weisen die Batteriezellen Kenngrößen der Batteriezelle, eine Belastungskenngröße der Batteriezelle, eine Temperatur der Batteriezelle und/oder eine Alterungskenngröße der Batteriezelle auf.

Bei einer weiteren möglichen Ausführungsform des erfindungsgemäßen Verfahrens weisen die ermittelten Rauschanteile ein Prozessrauschen und/oder ein Messrauschen auf.

Bei einer möglichen Ausführungsform des erfindungsgemäßen Verfahrens umfasst das Prozessrauschen ein Prozessrauschen der Batteriezellenzustände und/oder ein Prozessrauschen der Batteriezellenparameter.

Bei einer weiteren möglichen Ausführungsform des erfindungsgemäßen Verfahrens weist ein Zustandsvektor des Zustandsschätzers des dualen Kalman-Filters die Batteriezellenzustände der Batteriezelle auf und ein Zustandsvektor des Parameterschätzers des dualen Kalman-Filters weist die Batteriezellenparameter der Batteriezelle auf.

Bei einer weiteren möglichen Ausführungsform des erfindungsgemäßen Verfahrens wird eine Belastung der Batteriezelle anhand der detektierten Batteriezellenzustände und der detektierten Batteriezellenparameter gesteuert.

Bei einer weiteren möglichen Ausführungsform des erfindungsgemäßen Verfahrens werden die durch den Zustandsschätzer des dualen Kalman-Filters angepassten Batteriezellenzustände der Batteriezelle und die durch den Parameterschätzer des dualen Kalman-Filters angepassten Batteriezellenparameter der Batteriezelle an eine Steuereinheit zur Steuerung einer an der Batteriezelle angeschlossenen Last und/oder zur Steuerung einer an der Batteriezelle angeschlossenen Stromquelle ausgegeben.

Bei der angeschlossenen Last kann es sich beispielsweise um einen Elektromotor handeln.

Bei einer weiteren möglichen Ausführungsform des erfindungsgemäßen Verfahrens wird das charakteristische Parameterverhalten der Batteriezelle aus einem Datenspeicher ausgelesen.

Bei einer weiteren möglichen Ausführungsform des erfindungsgemäßen Verfahrens gibt das charakteristische Parameterverhalten der Batteriezelle für jeden Batteriezellenparameter, dessen Mittelwert und/oder dessen Varianz bezogen auf jeden Batteriezellenzustand und/oder auf Basis sensorisch erfasster Messgrößen der Batteriezelle an.

Bei einer weiteren möglichen Ausführungsform des erfindungsgemäßen Verfahrens wird das gespeicherte charakteristische Parameterverhalten der Batteriezelle auf Basis sensorisch erfasster Messgrößen bestimmt.

Bei einer möglichen Ausführungsform des erfindungsgemäßen Verfahrens umfassen die sensorisch erfassten Messgrößen einen Klemmenstrom, eine Klemmenspannung und/oder eine Temperatur der betreffenden Batteriezelle.

Bei einer weiteren möglichen Ausführungsform des erfindungsgemäßen Verfahrens wird ein Prozessrauschen eines Batteriezellenparameters in Abhängigkeit von dessen ausgelesenen charakteristischen Parameterverhalten bezogen auf einen Batteriezellenzustand und/oder auf Basis sensorisch erfasster Messgrößen und in Abhängigkeit einer zeitlichen Änderung dieses Batteriezellenzustandes und/oder auf Basis sensorisch erfasster Messgrößen ermittelt.

Bei einer weiteren möglichen Ausführungsform des erfindungsgemäßen Verfahrens wird ein Prozessrauschen eines Batteriezellenzustandes in Abhängigkeit von dessen ausgelesenen Parameterverhalten bezogen auf mindestens einen Batteriezellenparameter ermittelt.

Bei einer weiteren möglichen Ausführungsform des erfindungsgemäßen Verfahrens wird für jede sensorisch erfasste Messgröße dessen Messgrößenrauschen auf Basis von einem Mittelwert und/oder einer Varianz eines Rauschverhaltens des entsprechenden Messgrößensensors bezogen auf die Messgröße, die aus einem Datenspeicher ausgelesen wird, berechnet.

Bei einer weiteren möglichen Ausführungsform des erfindungsgemäßen Verfahrens wird das berechnete Messgrößenrauschen aller Messgrößen zur Ermittlung des Messrauschens addiert.

Bei einer weiteren möglichen Ausführungsform des erfindungsgemäßen Verfahrens wird eine Stabilität des dualen Kalman-Filters überwacht und das Anpassen der jeweiligen Batteriezellenzustände durch den Zustandsschätzer des dualen Kalman-Filters und der jeweiligen Batteriezellenparameter durch den Parameterschätzer des dualen Kalman-Filters ausgesetzt, sobald eine drohende Instabilität des dualen Kalman-Filters erkannt wird.

Bei einer weiteren möglichen Ausführungsform des erfindungsgemäßen Verfahrens erfolgt die Stabilitätsüberwachung des dualen Kalman-Filters anhand eines Kovarianzverhaltens der Batteriezellenzustände und anhand eines Kovarianzverhaltens der Batteriezellenparameter.

Bei einer weiteren möglichen Ausführungsform des erfindungsgemäßen Verfahrens wird das Kovarianzverhalten eines Batteriezellenzustandes und/oder das Kovarianzverhalten eines Batteriezellenparameters des dualen Kalman-Filters mit einem zugehörigen gespeicherten Soll-Kovarianzverhalten verglichen.

Bei einer weiteren möglichen Ausführungsform des erfindungsgemäßen Verfahrens wird das Anpassen eines Batteriezellenzustandes durch den Zustandsschätzer des dualen Kalman-Filters ausgesetzt, sobald dessen Kovarianzverhalten das gespeicherte zugehörige Soll-Kovarianzverhalten des jeweiligen Batteriezellenzustandes überschreitet.

Weiterhin wird bei einer möglichen Ausführungsform des erfindungsgemäßen Verfahrens das Anpassen eines Batteriezellenparameters durch den Parameterschätzer des dualen Kalman-Filters ausgesetzt, sobald dessen Kovarianzverhalten das gespeicherte zugehörige Soll-Kovarianzverhalten des jeweiligen Batteriezellenparameters überschreitet.

Bei einer weiteren möglichen Ausführungsform des erfindungsgemäßen Verfahrens weist das gespeicherte Soll-Kovarianzverhalten eine exponentiell über die Zeit abfallende Trichterfunktion auf, deren Koeffizienten konfiguriert werden.

Die Erfindung schafft ferner gemäß einem weiteren Aspekt eine Vorrichtung zur Detektion von Batteriezellenzuständen und/oder Batteriezellenparametern mindestens einer Batteriezelle mit den in Patentanspruch 20 angegebenen Merkmalen.

Die Erfindung schafft demnach eine Vorrichtung zur Detektion von Batteriezellenzuständen und/oder Batteriezellenparametern mindestens einer Batteriezelle mit:

einem dualen Kalman-Filter, das einen Zustandsschätzer zur Schätzung von Batteriezellenzuständen und einen Parameterschätzer zur Schätzung von Batteriezellenparametern aufweist, und mit einer Ermittlungseinheit, die geeignet ist, Rauschanteile des Zustandsschätzers und des Parameterschätzers anhand eines gespeicherten charakteristischen Parameterverhaltens der Batteriezelle zu ermitteln,

wobei die Batteriezellenzustände und die Batteriezellenparameter an ein vorgegebenes Batteriezellenmodell der Batteriezelle durch das duale Kalman-Filter auf Basis der durch die Ermittlungseinheit ermittelten Rauschanteile automatisch anpassbar sind.

Bei einer möglichen Ausführungsform der erfindungsgemäßen Vorrichtung ist der Zustandsschätzer des dualen Kalman-Filters durch ein erstes Kalman-Filter und der Parameterschätzer des dualen Kalman-Filters durch ein zweites Kalman-Filter gebildet.

Bei einer möglichen Ausführungsform der erfindungsgemäßen Vorrichtung weisen die beiden Kalman-Filter des dualen Kalman-Filters jeweils ein Lineares Kalman-Filter, ein Extended Kalman-Filter, ein Unscented Kalman-Filter, ein Square-Root Unscented Kalman-Filter oder ein Central-Difference-Kalman-Filter auf.

Bei einer weiteren möglichen Ausführungsform der erfindungsgemäßen Vorrichtung werden die durch den Zustandsschätzer des dualen Kalman-Filters angepassten Batteriezellenzustände und die durch den Parameterschätzer des dualen Kalman-Filters angepassten Batteriezellenparameter der Batteriezelle an eine Steuereinheit ausgegeben, welche zur Steuerung einer an der Batteriezelle angeschlossenen Last, insbesondere eines Elektromotors, und/oder zur Steuerung einer an der Batteriezelle angeschlossenen Stromquelle, vorgesehen ist.

Bei einer weiteren möglichen Ausführungsform der erfindungsgemäßen Vorrichtung wird das duale Kalman-Filter von einer Stabilitätsüberwachungseinheit hinsichtlich seiner Stabilität überwacht.

Bei einer weiteren möglichen Ausführungsform der erfindungsgemäßen Vorrichtung sind an der Batteriezelle Batteriezellensensoren vorgesehen, die Messgrößen der Batteriezelle sensorisch erfassen.

Bei einer weiteren möglichen Ausführungsform der erfindungsgemäßen Vorrichtung weisen die Batteriezellensensoren einen Sensor zur Erfassung einer Klemmspannung der Batteriezelle, einen Sensor zur Erfassung eines Klemmstroms der Batteriezelle und einen Temperatursensor zur Erfassung einer Temperatur der Batteriezelle auf.

Bei einer weiteren möglichen Ausführungsform der erfindungsgemäßen Vorrichtung erhält das duale Kalman-Filter eingangsseitig die durch die Batteriezellensensoren sensorisch erfassten Messgrößen.

Die Erfindung schafft gemäß einem weiteren Aspekt ein Verfahren zum Überwachen eines stabilen Konvergenzverhaltens eines Kalman-Filters, welches Zustände und/oder Parameter eines Energiespeichersystems schätzt.

Die Erfindung schafft demnach gemäß dem dritten Aspekt ein Verfahren zum Überwachen eines stabilen Konvergenzverhaltens eines Kalman-Filters, das Zustände und/oder Parameter eines Energiespeichersystems schätzt, wobei ein durch das Kalman-Filter bereitgestelltes Kovarianzverhalten hinsichtlich mindestens eines Zustandes und/oder eines Parameters des Energiespeichersystems mit einem entsprechenden Soll-Kovarianzverhalten des Zustandes und/oder Parameters verglichen wird, wobei das Kalman-Filter für jeden Zustand und/oder jeden Parameter des Energiespeichersystems, dessen Kovarianzverhalten das entsprechende Soll-Kovarianzverhalten überschreitet, automatisch deaktiviert wird.

Im Weiteren werden mögliche Ausführungsformen der verschiedenen Aspekte der Erfindung unter Bezugnahme auf die beigefügten Figuren näher erläutert.

Es zeigen:

Fig. 1 einen elektrischen Ersatzschaltkreis für eine Batteriezelle wie er bei einem herkömmlichen Batterie-Management-System verwendet werden kann;

Fig. 2 ein einfaches Ablaufdiagramm zur Darstellung eines möglichen Ausführungsbeispiels eines erfindungsgemäßen Verfahrens zum Detektieren von Batteriezellenzuständen und von Batteriezellenparametern mindestens einer Batteriezelle gemäß einem Aspekt der vorliegenden Erfindung;

Fig. 3 ein Blockschaltbild zur Darstellung eines exemplarischen Ausführungsbeispiels einer erfindungsgemäßen Vorrichtung zur Detektion von Batteriezellenzuständen und/oder Batteriezellenparametern einer Batteriezelle gemäß einem weiteren Aspekt der Erfindung;

Fig. 4 ein Blockschaltbild zur Darstellung eines Ausführungsbeispiels eines Kalman-Filters, welches bei dem erfindungsgemäßen Verfahren und bei der erfindungsgemäßen Vorrichtung verwendet werden kann;

Fig. 5 ein weiteres Blockschaltbild zur Darstellung der Struktur eines dualen Kalman-Filters, wie er bei dem erfindungsgemäßen Verfahren und der erfindungsgemäßen Vorrichtung eingesetzt werden kann;

Fig. 6 zeigt ein Beispiel für ein bei dem erfindungsgemäßen Verfahren verwendbaren Batteriemodell einer Batteriezelle;

Figuren 7A, 7B zeigen exemplarisch ein mögliches Rauschverhalten von Spannungs- und Stromsensoren bei einem erfindungsgemäßen Batterie-Management-System;

Figuren 8A, 8B zeigen exemplarisch ein Rauschverhalten eines bei dem erfindungsgemäßen Verfahren eingesetzten Batteriemodells;

Figuren 9A bis 9D zeigen Diagramme zur Darstellung einer Temperatur und Ladezustandsabhängigkeit von Parametern des Batteriemodells;

Figuren 10A bis 10D zeigen Diagramme zur Darstellung einer normalisierten Entladekapazität bei verschiedenen herkömmlichen Lithium-Ionen-Batterien;

Figuren 11A bis 11D zeigen Diagramme zur Darstellung einer Varianz der Änderung der Batteriezellenparameter und einer Zustandsänderung bezüglich des Ladezustandes einer Batteriezelle;

Figuren 12A bis 12D zeigen Diagramme zur Darstellung der Varianz der Änderung einer Batteriezellenkapazität bezüglich eines Klemmenstromes bei einer Batteriezelle;

Fig. 13 zeigt eine Abbildung zur Darstellung eines theoretischen Verlaufs einer Kovarianz;

Fig. 14 zeigt exemplarisch den Verlauf einer Diffusionsspannung innerhalb einer Trichterfunktion wie sie bei dem erfindungsgemäßen Verfahren und der erfindungsgemäßen Vorrichtung zur Stabilitätsüberwachung eingesetzt werden kann.

Wie man aus Fig. 2 erkennen kann, umfasst das erfindungsgemäße Verfahren zum Detektieren von Batteriezellenzuständen BZZ und von Batteriezellenparametern BZP im Wesentlichen zwei Schritte.

In einem ersten Schritt S1 werden Rauschanteile n, v eines Zustandsschätzers eines dualen Kalman-Filters und Rauschanteile n, v eines Parameterschätzers des dualen Kalman-Filters anhand eines charakteristischen Parameterverhaltens einer Batteriezelle bezüglich mindestens einer Batteriezellenkenngröße BZK der Batteriezelle BZ ermittelt.

In einem weiteren Schritt S2 werden Batteriezellenzustände BZZ und Batteriezellenparameter BZP an ein vorgegebenes Batteriemodell BM der Batteriezelle BZ durch das duale Kalman-Filter auf Basis der im Schritt S1 ermittelten Rauschanteile n, v angepasst.

Die im Schritt S1 ermittelten Rauschanteile n, v umfassen bei einer möglichen Ausführungsform ein Prozessrauschen v und ein Messrauschen n. Das ermittelte Prozessrauschen v kann ein Prozessrauschen $v_{BZZ}$ der Batteriezellenzustände BZZ und/oder ein Prozessrauschen $v_{BZP}$ der Batteriezellenparameter BZP umfassen.

Das bei dem erfindungsgemäßen Verfahren gemäß Fig. 1 verwendete duale Kalman-Filter DKF weist zwei miteinander gekoppelte Kalman-Filter KF auf, wobei ein erstes Kalman-Filter als Zustandsschätzer und ein zweites Kalman-Filter als Parameterschätzer dient. Ein Zustandsvektor des Zustandsschätzers des dualen Kalman-Filters DKF weist die Batteriezellenzustände $x_{BZZ}$ der Batteriezelle BZ auf. Ein Zustandsvektor des Parameterschätzers des dualen Kalman-Filters DKF weist die Batteriezellenparameter $x_{BZP}$ der Batteriezelle BZ auf. Das im Schritt S1 verwendete charakteristische Parameterverhalten der Batteriezelle BZ wird bei einer möglichen Ausführungsform aus einem Datenspeicher ausgelesen. Das charakteristische Parameterverhalten der Batteriezelle BZ weist bei einer möglichen Ausführungsform für jeden Batteriezellenparameter BZP dessen Mittelwert $\mu_{BZP}$ und/oder dessen Varianz $\sigma_{BZP}$ bezogen auf jeden Batteriezellenzustand BZZ der Batteriezelle BZ auf. Das gespeicherte charakteristische Parameterverhalten der Batteriezelle BZ kann bei einer Ausführungsform auf Basis sensorisch erfasster Messgrößen MG bestimmt werden. Diese Messgrößen MG umfassen beispielsweise einen Klemmenstrom $I_{KL}$, eine Klemmenspannung $U_{KL}$ und/oder eine Temperatur der Batteriezelle BZ.

Bei einer möglichen Ausführungsform wird im Schritt S1 ein Prozessrauschen $v_{BZP}$ eines Batteriezellenparameters BZP in Abhängigkeit von dessen ausgelesenen charakteristischen Parameterverhalten bezogen auf einen Batteriezellenzustand BZZ und/oder auf Basis sensorisch erfasster Messgrößen MG in Abhängigkeit einer zeitlichen Änderung des Batteriezellenzustandes BZZ und/oder auf Basis sensorisch erfasster Messgrößen ermittelt.

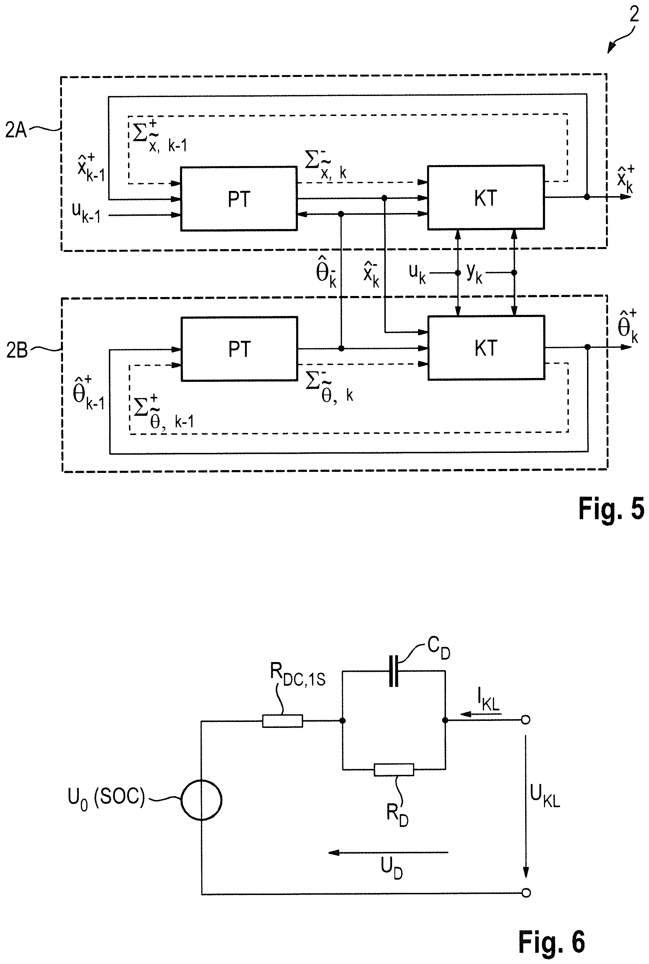

Die Batteriezellenzustände BZZ der Batteriezelle BZ umfassen bei einer möglichen Ausführungsform einen Ladezustand SOC (State of Charge) der Batteriezelle und/oder dynamische Batteriezellenzustände BZZ, insbesondere eine Diffusionsspannung $U_d$ der Batteriezelle BZ. Der Ladezustand SOC der Batteriezelle BZ liegt zwischen 0 und 1 bzw. zwischen 0 und 100 %. Die Diffusionsspannung $U_d$ ist diejenige Spannung in einem Batteriemodell BM, das beispielsweise in Fig. 6 dargestellt ist, welche über dem RC-Glied abfällt und dadurch ein dynamisches Verhalten zeigt. Die Batteriezellenzustände BZZ sind diejenigen physikalischen Größen des Batteriemodells BM, welche auch als Zustände in Differentialgleichungen vorkommen.

Die Batteriezellenparameter BZP der Batteriezelle BZ umfassen bei einer möglichen Ausführungsform einen Innenwiderstand $R_i$ der Batteriezelle, eine Nennkapazität $C_n$ der Batteriezelle BZ sowie resistive Dynamikkomponenten, insbesondere einen Diffusionswiderstand $R_d$ der Batteriezelle und/oder kapazitive Dynamikkomponenten, insbesondere eine Diffusionskapazität $C_D$ der Batteriezelle BZ. Die Batteriezellenparameter BZP umfassen diejenigen physikalischen Größen des Batteriemodells BM, die in den Differentialgleichungen als Parameter bzw. Wert vorkommen. Die Nennkapazität $C_n$ bildet einen Batteriezellenparameter BZP und gibt die aktuelle Kapazität der Batteriezelle BZ basierend auf den aktuellen Einflussgrößen an. Der Diffusionswiderstand $R_d$ stellt ebenfalls einen Batteriezellenparameter BZP dar und gibt den resistiven Anteil der dynamischen RC-Komponente des verwendeten Batteriemodells BM an, welches beispielhaft in Fig. 6 dargestellt ist. Die Diffusionskapazität $C_D$ der Batteriezelle BZ bildet ebenfalls einen Batteriezellenparameter BZP und stellt den kapazitiven Anteil der dynamischen RC-Komponente innerhalb des Batteriemodells gemäß Fig. 6 dar.

Die Batteriezellenkenngrößen BZK der Batteriezelle BZ umfassen bei einer möglichen Ausführungsform eine Belastungskenngröße der Batteriezelle BZ, eine Temperatur T der Batteriezelle BZ und/oder eine Alterungskenngröße der Batteriezelle BZ. Ein Beispiel für als Batteriezellenkenngröße BZK verwendete Belastungsgröße der Batteriezelle BZ ist die sogenannte C-Rate. Die C-Rate ist das Belastungsvielfache der Nennkapazität und beschreibt die Belastung der Batteriezelle BZ. 1C bedeutet beispielsweise bei einer Kapazität der Batteriezelle BZ von 1 Ah eine Belastung von 1A. Als Alterungskenngrößen der Batteriezelle BZ können beispielsweise Zyklenzahlen oder Kenngrößen hinsichtlich der Alterung der Batteriezelle verwendet werden.

Die in Schritt S1 verwendeten Rauschanteile n, v umfassen ein Prozessrauschen v und/oder ein Messrauschen n. Das Prozessrauschen kann bei einer möglichen Ausführungsform ein Prozessrauschen $v_{BZZ}$ der verschiedenen Batteriezellenzustände BZZ und/oder ein Prozessrauschen $v_{BZP}$ der verschiedenen Batteriezellenparameter BZP umfassen. Bei einer möglichen Ausführungsform umfasst das Prozessrauschen ein Prozessrauschen eines Ladezustandes SOL der Batteriezelle BZ und/oder ein Prozessrauschen einer Diffusionsspannung $U_d$ der Batteriezelle BZ. Weiterhin kann das Prozessrauschen auch ein Prozessrauschen $v_{BZP}$ von verschiedenen Batteriezellenparametern BZP umfassen, beispielsweise eines Innenwiderstandes der Batteriezelle BZ, einer Nennkapazität $C_N$ der Batteriezelle BZ, eines Diffusionswiderstandes $R_d$ der Batteriezelle BZ und/oder einer Diffusionskapazität $C_D$ der Batteriezelle BZ.

Das Prozessrauschen $v_{BZP}$ des Batteriezellenparameters BZP wird in Abhängigkeit von dessen ausgelesenen charakteristischen Parameterverhalten bezogen auf einen Batteriezellenzustand BZZ ermittelt. Alternativ kann das Prozessrauschen auch auf Basis sensorisch erfasster Messgrößen MG und in Abhängigkeit einer zeitlichen Änderung eines Batteriezellenzustandes BZZ ermittelt werden. Das Prozessrauschen $v_{BZZ}$ eines Batteriezellenzustandes BZZ wird in Abhängigkeit von dessen ausgelesenen Parameterverhalten bezogen auf mindestens einen Batteriezellenparameter BZP ermittelt. Bei einer möglichen Ausführungsform des erfindungsgemäßen Verfahrens werden für jede sensorisch erfasste Messgröße MG dessen Messgrößenrauschen auf Basis von einem Mittelwert $\mu_{MG}$ und/oder einer Varianz $\sigma_{MG}$ eines Rauschverhaltens des entsprechenden Messgrößensensors bezogen auf die Messgröße MG berechnet. Das berechnete Messgrößenrauschen aller Messgrößen kann zur Ermittlung des Messrauschens n addiert werden.

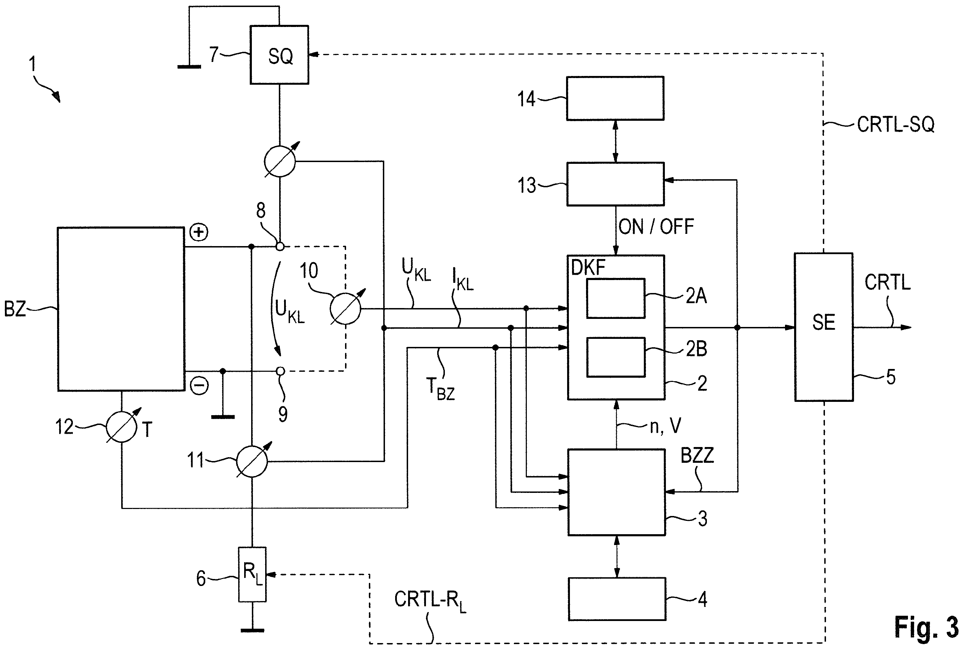

Fig. 3 zeigt ein Blockschaltbild zur Darstellung eines exemplarischen Ausführungsbeispiels einer erfindungsgemäßen Vorrichtung 1 zur Detektion von Batteriezellenzuständen BZZ und/oder Batteriezellenparametern BZP mindestens einer Batteriezelle BZ. Wie in Fig. 3 erkennbar, weist die erfindungsgemäße Detektionsvorrichtung 1 in dem dargestellten Ausführungsbeispiel ein duales Kalman-Filter 2 auf. Das duale Kalman-Filter 2 besteht aus zwei gekoppelten Kalman-Filtern. Das erste Kalman-Filter 2A des dualen Kalman-Filters 2 dient als Zustandsschätzer ZS zur Schätzung von Batteriezellenzuständen BZZ. Das zweite Kalman-Filter 2B des dualen Kalman-Filters 2 dient als Parameterschätzer PS zur Schätzung von Batteriezellenparametern BZP der Batteriezelle BZ. Die Detektionsvorrichtung 1 weist ferner eine Ermittlungseinheit 3 auf, die geeignet ist, Rauschanteile n, v des Zustandsschätzers 2A und des Parameterschätzers 2B anhand eines gespeicherten charakteristischen Parameterverhaltens der Batteriezelle BZ zu ermitteln. Das charakteristische Parameterverhalten der Batteriezelle BZ kann beispielsweise in einem Datenspeicher 4 abgespeichert sein. Die Batteriezellenzustände BZZ und die Batteriezellenparameter BZP sind durch das duale Kalman-Filter 2 auf Basis der durch die Ermittlungseinheit 3 ermittelten Rauschanteile n, v automatisch an ein vorgegebenes Batteriemodell BM der Batteriezelle BZ anpassbar. Der Zustandsschätzer ZS des dualen Kalman-Filters 2 wird durch ein erstes Kalman-Filter 2A und der Parameterschätzer PS des dualen Kalman-Filters 2 durch ein zweites Kalman-Filter 2B gebildet. Bei einer möglichen Ausführungsform der erfindungsgemäßen Detektionsvorrichtung 1 werden die beiden Kalman-Filter 2A, 2B des dualen Kalman-Filters 2 jeweils durch ein Lineares Kalman-Filter LKF, ein Extended Kalman-Filter EKF, ein Unscented Kalman-Filter UKF, ein Square-Root Unscented Kalman-Filter SR-UKF oder durch ein Central-Difference-Kalman-Filter CD-KF gebildet. Der Kalman-Filter 2 liefert Schätzwerte für Systemzustandsgrößen x.

$$\dot{x} = A \cdot x + B \cdot u + v$$

$$y = C \cdot x + n$$

wobei x der Zustandsvektor ist,
A die Systemmatrix darstellt,
B die Eingangsmatrix darstellt,
u der deterministische Eingangs- oder auch Kontrollvektor ist,
v ein gaußverteiltes Prozessrauschen darstellt,
y einen Ausgangswert bildet, der sich aus der Ausgangsmatrix
C und dem gaußverteilten Messrauschen n ergibt.

Bei einer möglichen Ausführungsform kann als deterministische Eingangsgröße bzw. Kontrollvektor u der Klemmstrom $I_{KL}$ und/oder die Klemmspannung $U_{KL}$ der Batteriezelle BZ herangezogen werden.

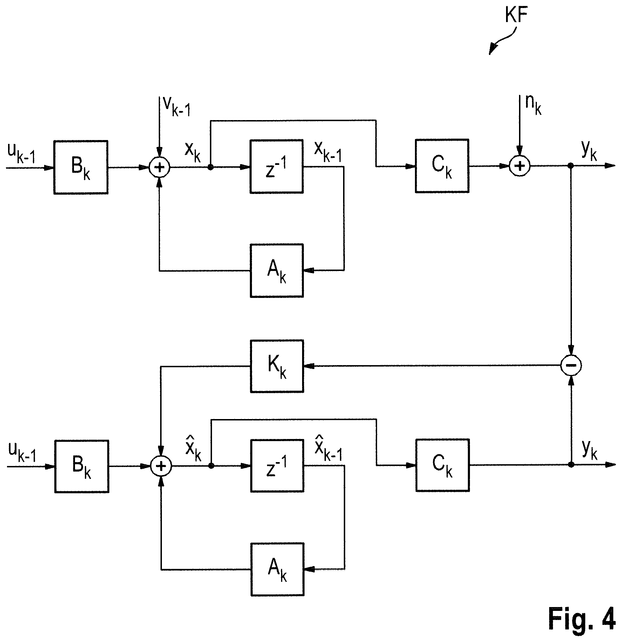

Fig. 4 zeigt die Struktur eines linearen diskreten Kalman-Filters 2. Das in Fig. 4 dargestellte lineare diskrete Kalman-Filter KF kann als Zustandsschätzer 2A und/oder als Parameterschätzer 2B des dualen Kalman-Filters 2 verwendet werden. Der obere Teil des in Fig. 4 dargestellten Kalman-Filters 2 bildet das Batteriemodell BM der Batteriezelle BZ ab, während der untere Teil des Kalman-Filters KF als adaptives Filter mittels der Kalman-Verstärkung Fehler in den Zuständen, insbesondere in den Batteriezellenzuständen BZZ, minimiert. x stellt den Zustandsvektor der Batteriezelle BZ dar und y den Ausgangsvektor der Batteriezelle BZ. Am Eingang des Kalman-Filters KF liegt ein deterministischer Kontrollvektor u an, wie beispielsweise die gemessene Klemmspannung $U_{KL}$ und/oder der gemessene Klemmstrom $I_{KL}$ der Batteriezelle BZ.
Für nichtlineare Systeme ist eine Diskretisierung über die Laplace-Transformation nicht möglich. Die Ausgangsform ist eine Zustandsraumdarstellung, die aus nichtlinearen Differentialgleichungen erster Ordnung besteht:

$$\dot{x} = f(x, u) + v$$

$$y = h(x, u) + n$$

wobei v das Prozessrauschen ist, n das Messrauschen darstellt,
x der Zustandsvektor der Batteriezelle,
y der Ausgangsvektor der Batteriezelle,
u der deterministische Eingangsvektor und
f, h nichtlineare Funktionen darstellen.

Bei einer möglichen Ausführungsform wird das als Zustandsschätzer ZS oder Parameterschätzer PS eingesetzte Kalman-Filter KF durch ein lineares Kalman-Filter gebildet. Bei einer weiteren möglichen Ausführungsform können auch Extended Kalman-Filter EKF eingesetzt werden. Hierbei wird die diskrete Systemmatrix A aus einer Taylor-Reihe approximiert. Die kontinuierliche Systemmatrix A und die Ausgangsmatrix C werden mithilfe einer Approximation erster Ordnung (Jacobi-Matrix) aus den nichtlinearen Differentialgleichungen angenähert.
Bei einer weiteren möglichen alternativen Ausführungsform werden die beiden Kalman-Filter KF des dualen Kalman-Filters 2 durch Unscented Kalman-Filter UKF gebildet. Das Unscented Kalman-Filter UKF gehört zur Gruppe der Sigma-Point-Kalman-Filter. Bei diesem Filtertyp wird das Problem des EKF hinsichtlich einer Linearisierung und der damit begrenzten Genauigkeit über ableitlose Ansätze gelöst. Hierbei werden die Systemgleichungen nicht über Taylor-Reihen approximiert, sondern durch Funktionsauswertungen an verschiedenen Stellen, den sogenannten Sigma-Punkten, berechnet. Die Sigma-Punkte werden als Eingänge der nichtlinearen Funktion derart gewählt, dass sie den Mittelwert und die Kovarianz des gesuchten Zustandes genau erfassen.

Bei einer weiteren möglichen Ausführungsform der erfindungsgemäßen Detektionsvorrichtung 1 werden die beiden Kalman-Filter 2A, 2B des dualen Kalman-Filters 2 durch Square-Root Unscented Kalman-Filter SR-UKF gebildet. Ein Nachteil bei der Verwendung von UKF-Filtern besteht darin, eine notwendige Quadratwurzel der Sigma-Punkte $S_k$ zu berechnen, um die Zustandskovarianz $P_k = S_k S_{Tk}$ zu bestimmen. Für die Sigma-Punkte kann beispielsweise eine Cholesky-Faktorisierung verwendet werden, die allerdings einen hohen Rechenaufwand erfordert. Mit einem Square-Root Unscented Kalman-Filter SR-UKF werden die Sigma-Punkte $S_k$ direkt mitgeführt, ohne dass eine Refaktorisierung zu jedem Zeitschnitt erforderlich ist. Das Kalman-Filter wird dadurch stabiler, da die Zustandskovarianz positiv-semidefinierte Werte annimmt und somit ein ähnlich rekursives Verhalten wie das lineare Kalman-Filter hat. Hierzu kann das Square-Root Unscented Kalman-Filter SR-UKF bei einer möglichen Ausführungsform verschiedene linear algebraische Techniken einsetzen, beispielsweise QR-Dekomposition, die Aktualisierung des Cholesky-Faktors oder die Methode kleinster Quadrate.

Bei einer weiteren möglichen Ausführungsform der erfindungsgemäßen Detektionsvorrichtung 1 können die beiden Kalman-Filter 2A, 2B des dualen Kalman-Filters 2 jeweils durch ein Central-Difference-Kalman-Filter CD-KF ausgebildet sein. Ein Central-Difference-Kalman-Filter CD-KF basiert auf einer Interpolationsformel von Stirling und ist in seinem schaltungstechnischen Aufbau dem Unscented Kalman-Filter UKF ähnlich.

Fig. 5 zeigt eine Struktur eines dualen Kalman-Filters 2, welches bei der erfindungsgemäßen Detektionsvorrichtung 1 eingesetzt werden kann. Das duale Kalman-Filter KF umfasst einen Zustandsschätzer 2A und einen Parameterschätzer 2B. Sowohl der Zustandsschätzer 2A als auch der Parameterschätzer 2B können durch ein Kalman-Filter 2 gebildet werden, wobei jedes Kalman-Filter 2 ein Prädiktionsteil PT und ein Korrekturteil KT umfasst. Der Zustandsschätzer 2A dient zur Schätzung von Batteriezellenzuständen BZZ der Batteriezelle BZ. Der Parameterschätzer 2B des dualen Kalman-Filters 2 dient zur Schätzung von Batteriezellenparametern BZP der Batteriezelle BZ. Die Batteriezellenzustände BZZ und die Batteriezellenparameter BZP werden an ein vorgegebenes Batteriemodell BM der Batteriezelle BZ durch das duale Kalman-Filter 2 auf Basis der ermittelten Rauschanteile n, v automatisch angepasst. Diese Rauschanteile n, v werden durch die in Fig. 3 dargestellte Ermittlungseinheit 3 ermittelt.

Die durch den Zustandsschätzer 2A des dualen Kalman-Filters 2 angepassten Batteriezellenzustände BZZ und die durch den Parameterschätzer 2B des dualen Kalman-Filters 2 angepassten Batteriezellenparameter BZP der Batteriezelle BZ werden bei einer möglichen Ausführungsform an eine Steuereinheit 5 ausgegeben, wie in Fig. 3 dargestellt. Diese Steuereinheit 5 dient bei einer möglichen Ausführungsform zur Steuerung einer an der Batteriezelle BZ angeschlossenen Last, beispielsweise eines Elektromotors. Weiterhin kann die Steuereinheit 5 bei einer alternativen Ausführungsform zur Steuerung einer an der Batteriezelle BZ angeschlossenen Stromquelle vorgesehen sein.

Wie in Fig. 3 dargestellt, liefert die Steuereinheit 5 bei einer möglichen Ausführungsform Steuersignale CRTL-RL für eine an die Batteriezelle BZ angeschlossenen elektrischen Last 6. Bei dieser Last 6 kann es sich beispielsweise um einen Elektromotor eines Elektrofahrzeuges handeln. Weiterhin liefert die Steuereinheit 5 bei dem in Fig. 3 dargestellten Ausführungsbeispiel ein Steuersignal CRTL-SQ für eine an die Batteriezelle BZ angeschlossene Stromquelle 7. Die Stromquelle 7 ist an eine erste Batteriezellenklemme 8 der Batteriezelle BZ angeschlossen. Die Last 6 ist an eine zweite Batteriezellenklemme 9 der Batteriezelle BZ angeschlossen.

Bei dem in Fig. 3 dargestellten Ausführungsbeispiel sind an der Batteriezelle BZ verschiedene Sensoren vorgesehen. Diese Sensoren umfassen bei einer möglichen Ausführungsform einen Spannungssensor 10, einen Stromsensor 11 und einen Temperatursensor 12. Der Spannungssensor 10 misst eine Klemmenspannung $U_{KL}$ zwischen den beiden Batteriezellenklemmen 8, 9. Der Stromsensor 11 dient bei dem dargestellten Ausführungsbeispiel zur Messung eines Klemmenstroms $I_{KL}$ der Batteriezelle BZ. Weiterhin dient der Temperatursensor 12 zur Temperaturmessung einer Temperatur T der Batteriezelle BZ. Die Klemmenspannung $U_{KL}$, der Klemmenstrom $I_{KL}$ sowie die Temperatur T der Batteriezelle BZ stellen sensorisch erfasste Messgrößen MG dar. Diese Messgrößen MG werden als deterministische Eingangsmessgrößen dem dualen Kalman-Filter 2 zugeführt, wie aus dem Blockschaltbild gemäß Fig. 3 erkennbar. Die Messgrößen MG, d.h. die Klemmenspannung $U_{KL}$, der Klemmenstrom $I_{KL}$ und/oder die Temperatur T der Batteriezelle BZ, werden auch der Ermittlungseinheit 3 zugeführt. Die Ermittlungseinheit 3 ermittelt die Rauschanteile n, v des Zustandsschätzers 2A und des Parameterschätzers 2B anhand eines gespeicherten charakteristischen Parameterverhaltens der Batteriezelle BZ. In dem Datenspeicher 4 sind bei einer möglichen Ausführungsform für jeden Batteriezellenparameter BZP dessen Mittelwert $\mu_{BZP}$, dessen Varianz $\sigma_{BZP}$ bezogen auf jeden Batteriezellenzustand BZZ sowie die sensorisch erfassten Messgrößen MG der Batteriezelle BZ gespeichert. Das Prozessrauschen $v_{BZP}$ der Batteriezellenparameter BZP wird durch die Ermittlungseinheit 3 in Abhängigkeit von dessen ausgelesenen charakteristischen Parameterverhalten bezogen auf einen Batteriezellenzustand BZZ auf Basis der sensorisch erfassten Messgrößen MG ermittelt. Weiterhin wird ein Prozessrauschen $v_{BZZ}$ des Batteriezellenzustandes BZZ in Abhängigkeit von dessen ausgelesenen Parameterverhalten durch die Ermittlungseinheit 3 bezogen auf mindestens einen Batteriezellenparameter BZP ermittelt. Für jede sensorisch erfasste Messgröße MG wird durch die Ermittlungseinheit 3 dessen Messgrößenrauschen n auf Basis von einem Mittelwert $\mu_{MG}$ und/oder einer Varianz $\sigma_{MG}$ eines Rauschverhaltens des entsprechenden Messgrößensensors 10, 11, 12 bezogen auf die Messgröße MG, die aus dem Datenspeicher 4 ausgelesen werden, berechnet. Das berechnete Messgrößenrauschen der verschiedenen Messgrößen MG kann zur Ermittlung des Messrauschens n durch die Ermittlungseinheit 3 addiert werden. Das ermittelte Messrauschen n wird dem dualen Kalman-Filter 2 zugeführt, wie in Fig. 3 dargestellt.

Das duale Kalman-Filter 2 umfasst zwei Kalman-Filter 2A, 2B, die parallel zueinander eingestellt werden können. Beide Kalman-Filter 2A, 2B des dualen Kalman-Filters 2 können denselben Eingangsvektor $u_{k-1}$ und dieselben Messgrößen $y_k$ aufweisen. In dem jeweiligen Prädiktionsteil PT der beiden Kalman-Filter 2A, 2B bilden die zuvor errechneten Zustände und Parameter die Eingangsvariablen des aktuellen Zeitschrittes. Die beiden Kalman-Filter 2A, 2B innerhalb des dualen Kalman-Filters 2 können den gleichen Filtertyp aufweisen oder durch unterschiedliche Filtertypen gebildet werden. Der Zustandsvektor x des dualen Kalman-Filters 2 umfasst den Zustandsvektor des Zustandsschätzers 2A und den Zustandsvektor des Parameterschätzers 2B. Der Zustandsvektor $x_{BZZ}$ des Zustandsschätzers 2A weist die Batteriezellenzustände BZZ der Batteriezelle BZ auf. Der Zustandsvektor des Parameterschätzers 2B des dualen Kalman-Filters 2 weist die Batteriezellenparameter $x_{BZP}$ der Batteriezelle BZ auf. Da die zugeführten Messgrößen MG des Zustandsschätzers 2A und des Parameterschätzers 2B dieselben sind, ändert sich lediglich die zusätzliche Abhängigkeit des Parametervektors in der nichtlinearen Ausgangsgleichung in der kontinuierlichen Zustandsraumdarstellung des Parameterschätzers 2B:

$$y = g(x, u, w) + n$$

Bei dieser Ausführungsform erfolgt die Anpassung des Batteriezellenparameters BZP primär über das Parameterprozessrauschen.

Bei einer möglichen Ausführungsform des erfindungsgemäßen Verfahrens wird eine Stabilität des dualen Kalman-Filters 2 überwacht. Dabei wird eine Anpassung der jeweiligen Batteriezellenzustände BZZ durch den Zustandsschätzer 2A des dualen Kalman-Filters 2 und der jeweiligen Batteriezellenparameter BZP durch den Parameterschätzer 2B des dualen Kalman-Filters 2 ausgesetzt, sobald eine drohende Instabilität des dualen Kalman-Filters 2 erkannt wird. Bei einer möglichen Ausführungsform erfolgt die Stabilitätsüberwachung des dualen Kalman-Filters 2 anhand eines Kovarianzverhaltens $P_{BZZ}$ der Batteriezellenzustände BZZ und anhand eines Kovarianzverhaltens $P_{BZP}$ der Batteriezellenparameter BZP. Das Kovarianzverhalten $P_{BZZ}$ des Batteriezellenzustandes BZZ und/oder das Kovarianzverhalten $P_{BZP}$ eines Batteriezellenparameters BZP des dualen Kalman-Filters 2 wird bei einer möglichen Ausführungsform mit einer zugehörigen gespeicherten Soll-Kovarianz verglichen. Eine Anpassung eines Batteriezellenzustandes BZZ durch den Zustandsschätzer 2A des dualen Kalman-Filters 2 wird ausgesetzt, sobald dessen Kovarianzverhalten $P_{BZZ}$ das gespeicherte zugehörige Soll-Kovarianzverhalten des jeweiligen Batteriezellenzustandes BZZ überschreitet. Weiterhin kann die Anpassung eines Batteriezellenparameters BZP durch den Parameterschätzer 2B des dualen Kalman-Filters 2 ausgesetzt werden, sobald dessen Kovarianzverhalten $P_{BZP}$ das gespeicherte zugehörige Soll-Kovarianzverhalten des jeweiligen Batteriezellenparameters BZP überschreitet. Bei einer möglichen Ausführungsform weist das gespeicherte Soll-Kovarianzverhalten eine exponentiell über die Zeit abfallende Trichterfunktion auf, deren Koeffizienten konfiguriert werden.

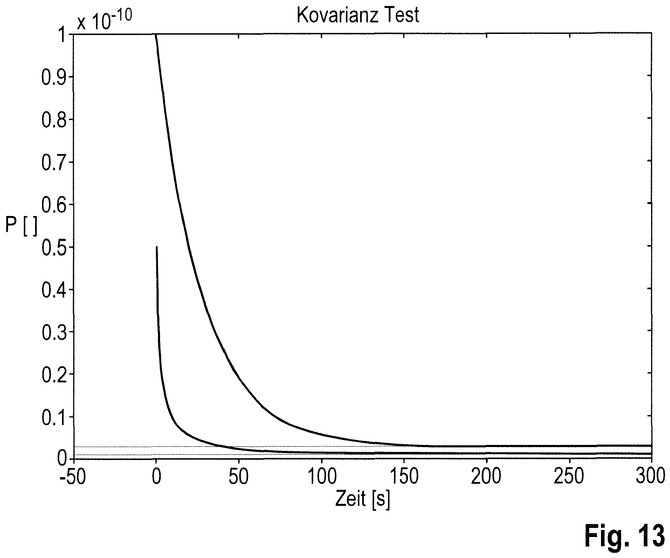

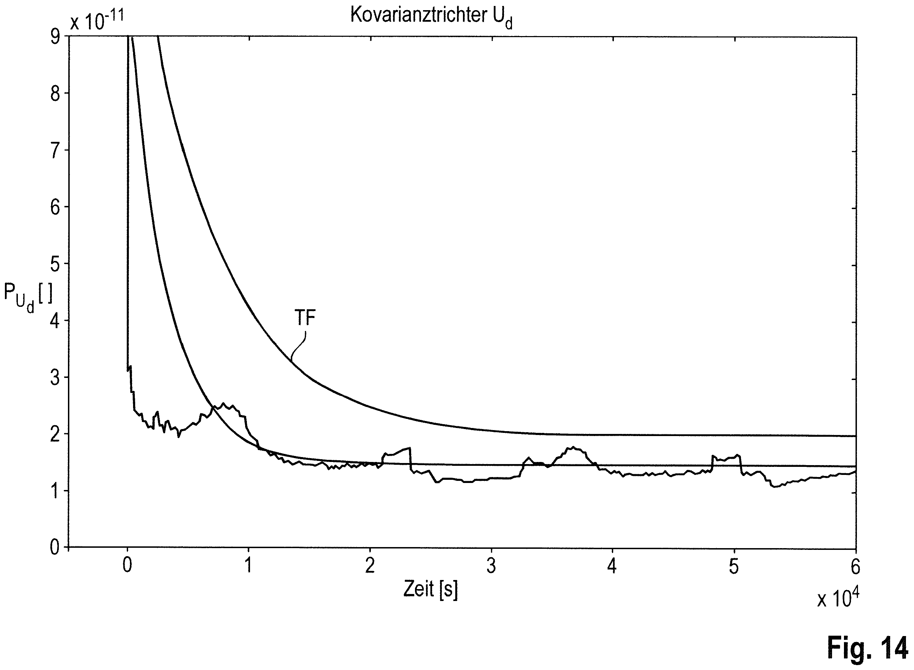

Bei dem in Fig. 3 dargestellten Ausführungsbeispiel besitzt die Detektionsvorrichtung 1 eine Stabilitätsüberwachungseinheit 13, welche geeignet ist, die Anpassung eines Batteriezellenzustandes BZZ durch den Zustandsschätzer 2A des dualen Kalman-Filters 2 und/oder die Anpassung eines Batteriezellenparameters BZP durch den Parameterschätzer 2B des dualen Kalman-Filters 2 auszusetzen, sobald das entsprechende Kovarianzverhalten ein gespeichertes zugehöriges Soll-Kovarianzverhalten überschreitet. Bei einer möglichen Ausführungsform ist das Soll-Kovarianzverhalten in einem Datenspeicher 14 der Detektionsvorrichtung 1 abgelegt. Das gespeicherte Soll-Kovarianzverhalten besitzt bei einer möglichen Implementierung eine exponentiell über die Zeit abfallende Trichterfunktion, wie sie in den Figuren 13, 14 dargestellt ist.

Fig. 6 zeigt exemplarisch ein Batteriemodell BM, welches bei dem erfindungsgemäßen Verfahren und der erfindungsgemäßen Detektionsvorrichtung 1 verwendet werden kann.

Der Widerstand $R_{DC1s}$ ist dabei ein kombinierter Widerstand, der den realen Zellinnenwiderstand $R_i$ der Batteriezelle BZ und alle innerhalb 1 Sek auftretenden dynamischen Vorgänge, beispielsweise Ladungstransfervorgänge, zusammenfasst. Der Widerstand $R_D$ stellt den Diffusionswiderstand der Batteriezelle BZ dar. Die Kapazität $C_D$ stellt die Diffusionskapazität der Batteriezelle BZ dar. Weiterhin sind in Fig. 6 die Klemmenspannung $U_{KL}$ der Batteriezelle BZ sowie der Klemmenstrom $I_{KL}$ der Batteriezelle BZ dargestellt. Weiterhin zeigt das Batteriemodell BM eine über den Diffusionswiderstand $R_D$ und die Diffusionskapazität $C_D$ anliegende Diffusionsspannung $U_D$. $U_0(SOC)$ ist die ladezustandsabhängige Ruhespannung der Batteriezelle (OCV-Spannung).

Der Ladezustand SoC ist definiert als der integrierte Klemmenstrom über den Belastungszeitraum bzw. die Ableitung des Ladezustandes SoC ist der Klemmenstrom $I_{KL}(t)$, bezogen auf die Kapazität der Batteriezelle $C_n$.

$$\dot{SOC} = \frac{1}{c_n} I_{KL}(t) \tag{1}$$

Die Diffusionsspannung $U_D$ kann aus einer Differentialgleichung erster Ordnung berechnet werden:

$$\dot{U}_D = -\frac{1}{R_D \cdot C_D} \cdot U_D(t) + \frac{1}{C_D} I_{KL}(t) \tag{2}$$

Daraus lässt sich nun die Zustandsraumdarstellung wie folgt zusammensetzen:

$$\begin{bmatrix} \ddot{U}_D \\ \dot{SOC} \end{bmatrix} = \begin{bmatrix} -\frac{1}{R_D C_D} & 0 \\ 0 & 0 \end{bmatrix} \begin{bmatrix} U_D \\ SOC \end{bmatrix} + \begin{bmatrix} \frac{1}{C_D} \\ \frac{1}{C_n} \end{bmatrix} I_{KL}(t) \tag{3}$$

Die Klemmspannung $U_{KL}$ errechnet sich aus den internen Spannungsabfällen der Batteriezelle BZ, hervorgerufen durch den Klemmenstrom $I_{KL}$ zu:

$$U_{KL}(t) = U_0(SOC) + R_{DC,1s} I_{KL}(t) + U_D(t) \tag{4}$$

Der Zustandsvektor x(t) beinhaltet bei diesem einfachen Ausführungsbeispiel somit:

$$[x_1, x_2]^T = [U_D(t), SOC(t)]^T. \tag{5}$$

Eine wesentliche Größe, die das Verhalten des Kalman-Filters 2 beeinflussen kann, ist das Rauschen, d.h. das Prozessrauschen v und das Messrauschen n. Das Messrauschen n berücksichtigt die Fehler in dem Messwert und dessen Auswirkungen auf die daraus zurückgeführte Modellanpassung. Das Prozessrauschen v berücksichtigt die Vereinfachung und Fehlertoleranz des Batteriemodells BM. Im Folgenden wird der jeweilige Rauschterm für das duale Kalman-Filter 2 hergeleitet, um eine schnelle und effiziente Anpassung in einer möglichen realen Applikation zu realisieren.

Die Berücksichtigung des Messrauschens n erfolgt in der Ausgangsgleichung:

$$y(t) = \mathbf{C} x(t) + n \tag{6}$$

Bei der Untersuchung der Ausgangsgleichung des verwendeten Batteriemodells BM können verschiedene Messrauschkomponenten identifiziert werden, nämlich das Messrauschen der Zellspannungsmessung, das Messrauschen des Stromsensors sowie ein Rauschwert hinsichtlich der Diffusionsspannung. Aus der Varianz σ der jeweiligen Terme kann das Messrauschen n hergeleitet werden:

$$U_{KL} = U_0(SOC) + R_{DC,1s}(I_{KL}(t) + \sigma_{I_{KL}}) + (U_D(t) + \sigma_{U_D}) + \sigma_{U_{KL}}$$
$$n = R_{DC,1s}\sigma_{I_{KL}} + \sigma_{U_D} + \sigma_{U_{KL}} \tag{7}$$

Die Gewichtung der drei Rauschanteile kann sich mitunter stark unterscheiden.

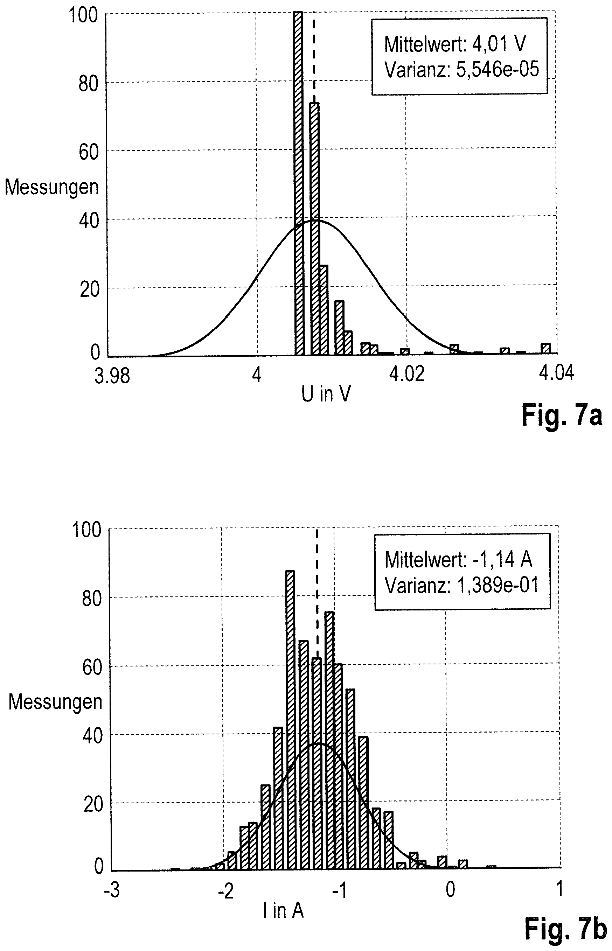

Figuren 7A, 7B zeigen beispielhaft das Rauschverhalten von Spannungs- und Stromsensoren des erfindungsgemäßen Batterie-Management-Systems. Fig. 7A zeigt das Rauschverhalten eines Spannungssensors des Batterie-Management-Systems, beispielsweise des in Fig. 3 dargestellten Spannungssensors 10. Fig. 7A zeigt die Verteilung von Messungen bezüglich der Klemmenspannung $U_{KL}$. Beispielsweise liegt der Mittelwert μ bei 4,01 V und die Varianz beträgt 6.546e-0.5.

Fig. 7B zeigt beispielhaft das Verhalten eines Stromsensors innerhalb des Batterie-Management-Systems, beispielsweise des in Fig. 3 dargestellten Stromsensors 11. Man erkennt die Anzahl der Messungen verteilt über verschiedene Klemmenströme $I_{KL}$. Der Mittelwert $\mu$ beträgt beispielsweise $\mu$ = -1,14 A und die Varianz $\sigma$ 1,389e-01.

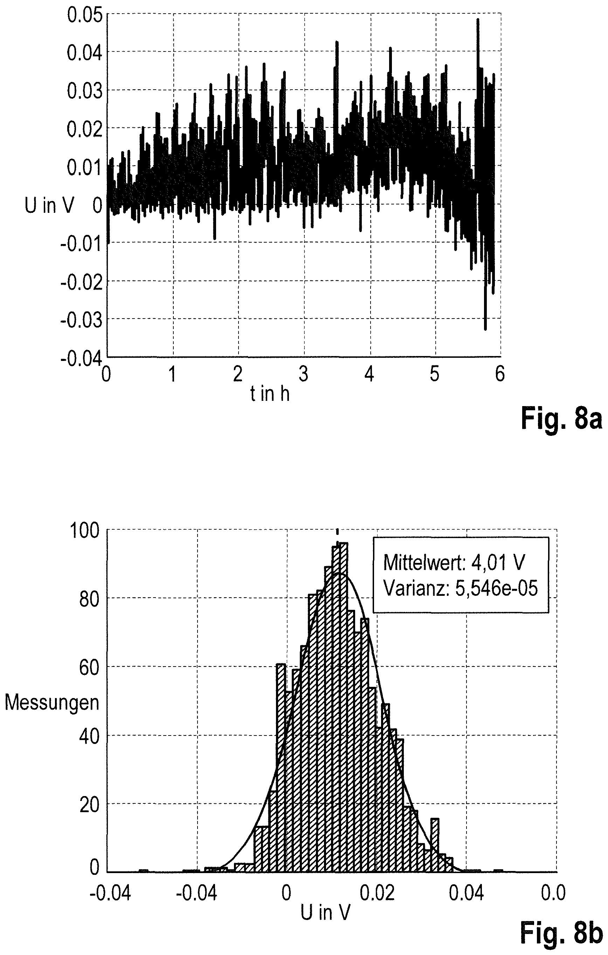

Die Figuren 8A, 8B zeigen ein Rauschverhalten des Batteriemodells BM. Fig. 8A zeigt einen Fehler zwischen Messung und Simulation über die Zeit t. Fig. 8A zeigt einen absoluten Fehler der Batteriemodellierungen in Bezug auf eine wahre Zellspannung der Batteriezelle BZ.

Fig. 8B zeigt ein Histogramm der Abweichung. Fig. 8B zeigt somit ein zugehöriges Rauschverhalten. Fig. 8B zeigt beispielsweise die Anzahl der Messungen für verschiedene Spannungen U.

Da sich der im Batteriemodell BM gemäß Fig. 6 dargestellte Innenwiderstand $R_{DC1s}$ bezüglich des Rauschens genauso verhält wie ein Parameter, kann dieser zusammen mit dem Parameterrauschen verglichen werden. Bei der Untersuchung des Prozessrauschens v1 des ersten Zustandes $U_D$ kann dieser wie folgt hergeleitet werden:

$$\dot{U}_D = -\frac{1}{R_D C_D}(U_D(t) + \sigma_{U_D}) + \frac{1}{C_D}(I_{KL}(t) + \sigma_{I_{KL}})$$

$$v_1 = -\frac{1}{R_D C_D}\sigma_{U_D} + \frac{1}{C_D}\sigma_{I_{KL}}$$

$$(8)$$

Für die Untersuchung des zweiten Prozessrauschanteils v2 des zweiten Batteriezellenzustandes SOC erfolgt die Herleitung zu:

$$\dot{SOC} = \frac{1}{C_n}(I_{KL}(t) + \sigma_{I_{KL}})$$

$$v_2 = \frac{1}{C_n}\sigma_{I_{KL}}$$

$$(9)$$

Bei der Modellierung des Prozessrauschens v kann auch der dritte Zustand $R_{dc1s}$ mitbetrachtet werden, da er sich gleich den Parametern verhält. Das Prozessrauschen der Batteriezellenparameter BZP legt fest, wie stark sich die einzelnen Batteriezellenparameter BZP ändern müssen. Bei herkömmlichen Anordnungen wird der Parameterschätzer 2B lediglich dafür verwendet, um feste Parameter bzw. Batteriezellenparameter BZP schätzen zu lassen, die sich nicht mehr ändern. Ein sich ändernder Batteriezellenparameter BZP kann zu einer Instabilität des dualen Kalman-Filters 2 führen.

Der Prozessrauschanteil $v_{BZP}$ kommt in der Zustandsraumdarstellung der Batteriezellenparameter BZP vor. Im Rahmen der Grundüberlegungen hinsichtlich des Kalman-Filters 2 bedeutet dieser Rauschwert nichts anderes als eine bestimmte Änderungswahrscheinlichkeit des entsprechenden Batteriezellenparameters BZP. Kann sich ein Batteriezellenparameter BZP über weite Bereiche sehr stark ändern, so entspricht dies einer hohen Varianz $\sigma$ des betreffenden Batteriezellenparameters BZP, während umgekehrt eine geringere Änderung einer sehr kleinen Varianz entspricht.

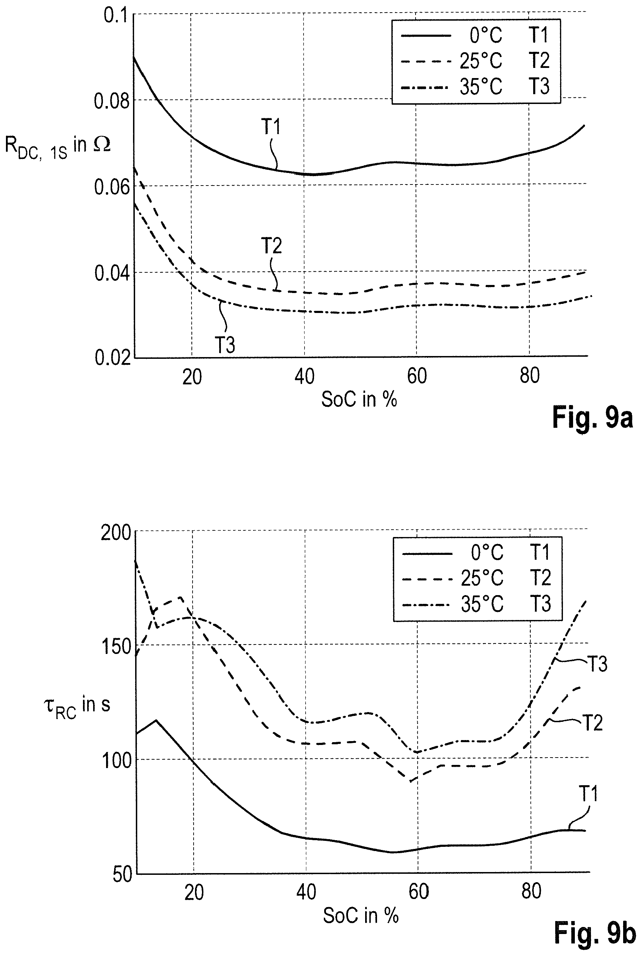

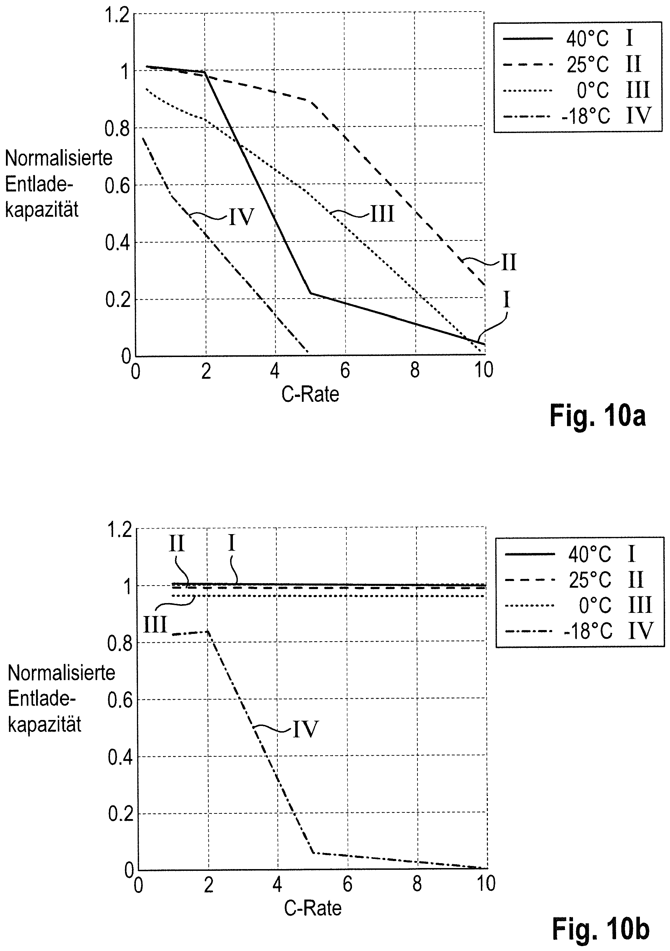

In den Figuren 9A bis 9D sowie 10A bis 10D ist eine Dynamikabhängigkeit der einzelnen Batteriezellenparameter BZP von der Temperatur T, dem Ladezustand SOC und der Belastung veranschaulicht. Wird daraus die Varianz $\sigma$ des entsprechenden Batteriezellenparameters BZP bezogen auf die jeweilige Einflussgröße bzw. Batteriezellenkenngröße BZK abgeleitet, kann ein Rauschterm des Batteriezellenparameters BZP bestimmt werden. Auf diese Weise kann beispielsweise bei dem dritten Batteriezellenparameter $R_{dc1s}$ und den beiden Batteriezellenparametern $R_D$, $C_D$ die Ladezustandsabhängigkeit betrachtet werden.

Fig. 9A zeigt die Abhängigkeit des Innenwiderstandes $R_{dc1s}$ von dem Ladezustand SOC als Batteriezellenzustand BZZ für verschiedene Temperaturen T.

Fig. 9B zeigt die Abhängigkeit einer Zeitkonstante $\tau_{CD}$ ($\tau=R_D x C_D$) von dem Ladezustand SOC für verschiedene Temperaturen.

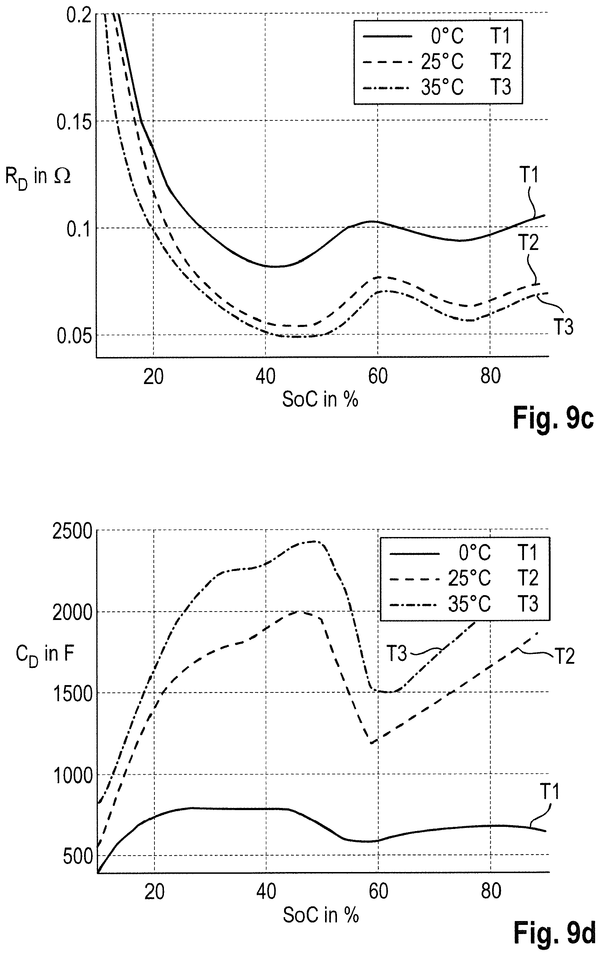

Fig. 9C zeigt die Abhängigkeit des Diffusionswiderstandes $R_D$ von dem Ladezustand SOC für verschiedene Temperaturen T. Weiterhin zeigt die Fig. 9D die Abhängigkeit der Diffusionskapazität $C_D$ von dem Ladezustand SOC für verschiedene Temperaturen T.

Die Kapazität $C_n$ bildet ebenfalls einen Batteriezellenparameter BZP. Figuren 10A bis 10D zeigen die normalisierte Entladekapazität für verschiedene typische Lithium-Ionen-Zellchemien. Fig. 10A zeigt eine normalisierte Entladekapazität für eine NMC-Batterie.

Fig. 10B zeigt eine normalisierte Entladekapazität für eine LFP-Batterie für verschiedene Temperaturen T.

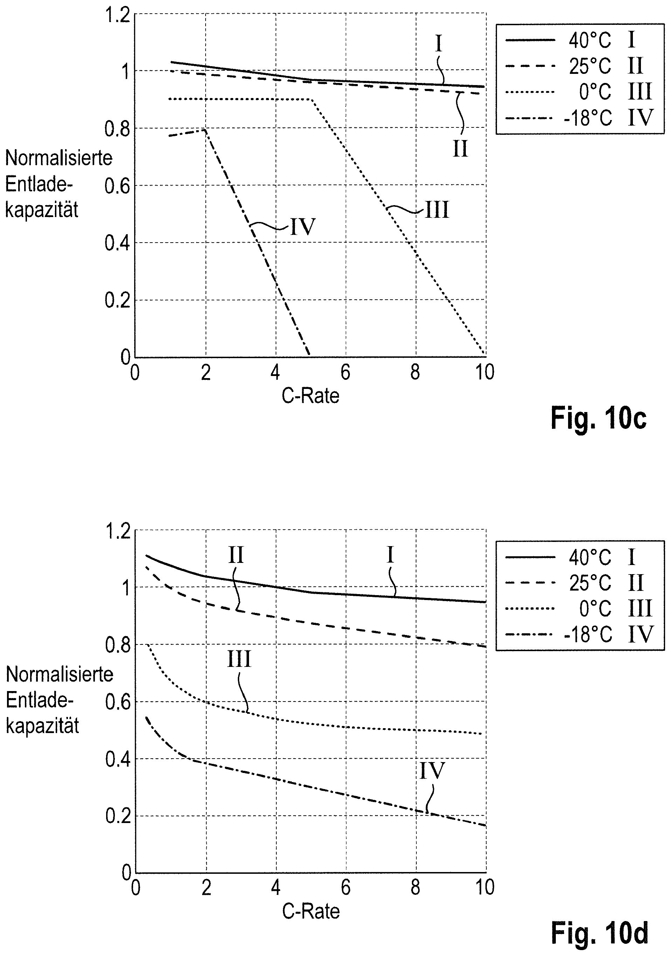

Fig. 10C zeigt die normalisierte Entladekapazität bezüglich der C-Rate für verschiedene Temperaturen T. Fig. 10D zeigt die normalisierte Entladekapazität über die C-Rate für verschiedene Temperaturen T für eine LTO-Batterie. Mit dem Batteriezellenparameter $C_n$ werden in den Figuren 10A bis 10D dessen Änderung bezüglich des Klemmstromes $I_{KL}$ bzw. hinsichtlich der C-Rate beobachtet. Dabei kann davon ausgegangen werden, dass sich die Temperatur T im Vergleich zu den anderen Größen nur relativ langsam ändert und daher nur einen Bruchteil der Rauschkovarianz ausmacht.

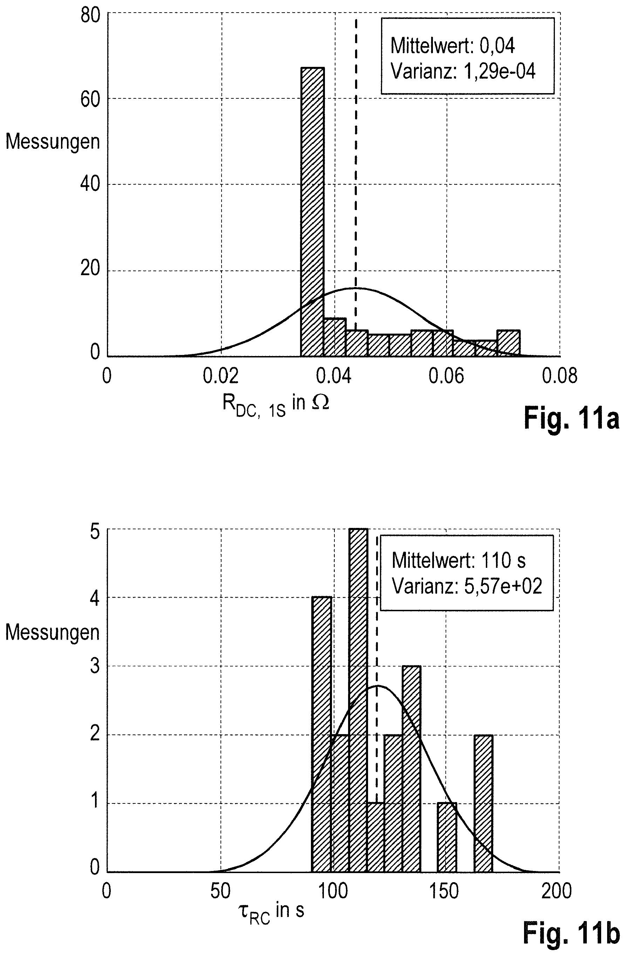

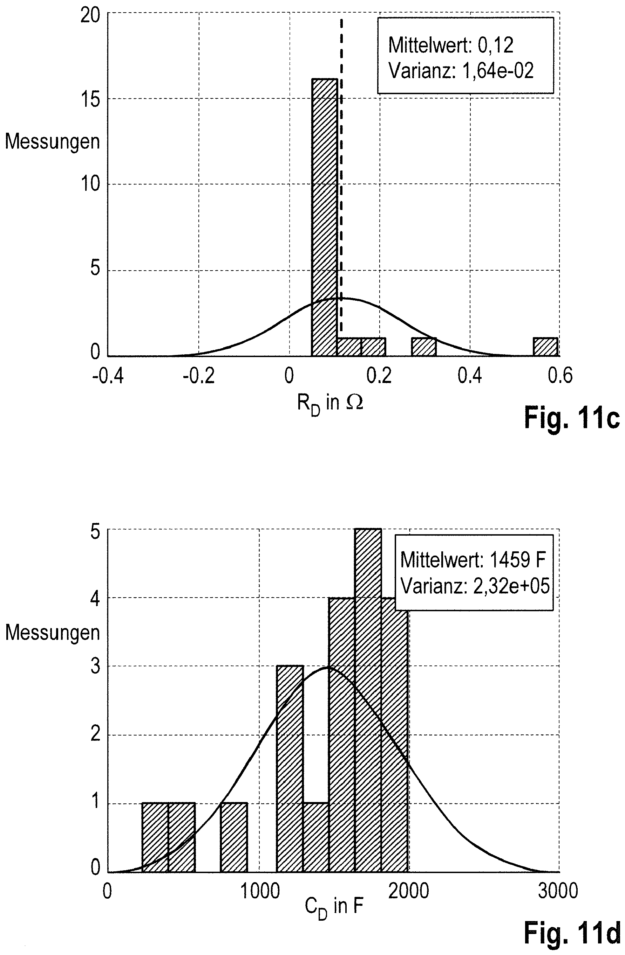

In den Figuren 11A bis 11D ist eine Varianz der Änderung der Parameter und eine Zustandsänderung bezüglich des Ladezustandes SOC dargestellt. Fig. 11A zeigt die Varianz des Innenwiderstandes $R_{dc,\,1s}$ hinsichtlich des Ladezustandes SOC. Fig. 11B zeigt die Varianz einer Zeitkonstante hinsichtlich des Ladezustandes SOC. Fig. 11C zeigt die Varianz des Diffusionswiderstandes $R_D$ hinsichtlich des Ladezustandes SOC. Fig. 11D zeigt die Varianz einer Diffusionskapazität $C_D$ hinsichtlich des Ladezustandes SOC.

Da die vom Ladezustand SOC abhängige Varianz vorliegt, kann die Differenz des Ladezustandes SOC für den Zykluszeitraum $t_2$-$t_2$, d.h. $(SOC(t_2)\text{-}SOC(t_1))$ verwendet werden:

$$v_3 = (SOC(t_2) - SOC(t_1))\sigma_{R_{DC,1s}}$$
$$r_2 = (SOC(t_2) - SOC(t_1))\sigma_{R_D}$$
$$r_3 = (SOC(t_2) - SOC(t_1))\sigma_{C_D}$$

$$v_{3_k} = (x_{2_k} - x_{2_{k-1}})\sigma_{R_{DC,1s}}$$
$$r_{2_k} = (x_{2_k} - x_{2_{k-1}})\sigma_{R_D}$$
$$r_{3_k} = (x_{2_k} - x_{2_{k-1}})\sigma_{C_D}$$

$$(10)$$

Wie bereits in den Figuren 10A bis 10D dargestellt, hängt die Batteriekapazität von verschiedenen Faktoren ab, insbesondere vom Klemmenstrom, der Temperatur, der Entladetiefe, Alterung sowie Rekuperation. Anhand der verschiedenen Abhängigkeiten kann basierend auf einer Modellierung des Prozessrauschanteils der Zellkapazität eine adaptive Methode implementiert werden, bei der der Anpassungsaufwand minimiert wird.

Bei dieser Modellierung kann die Abhängigkeit des sich dynamisch ändernden Klemmenstroms $I_{KL}$ berücksichtigt werden, wobei davon ausgegangen wird, dass sich die Temperatur T vergleichsweise langsam ändert und somit einen untergeordneten Beitrag zur Varianz σ beisteuert. Da bei tieferen Temperaturen T die Kapazität der Batteriezelle BZ deutlich einbricht, wird bei der Varianzuntersuchung das Zellverhalten bei einer Temperatur T = 0°C verwendet.

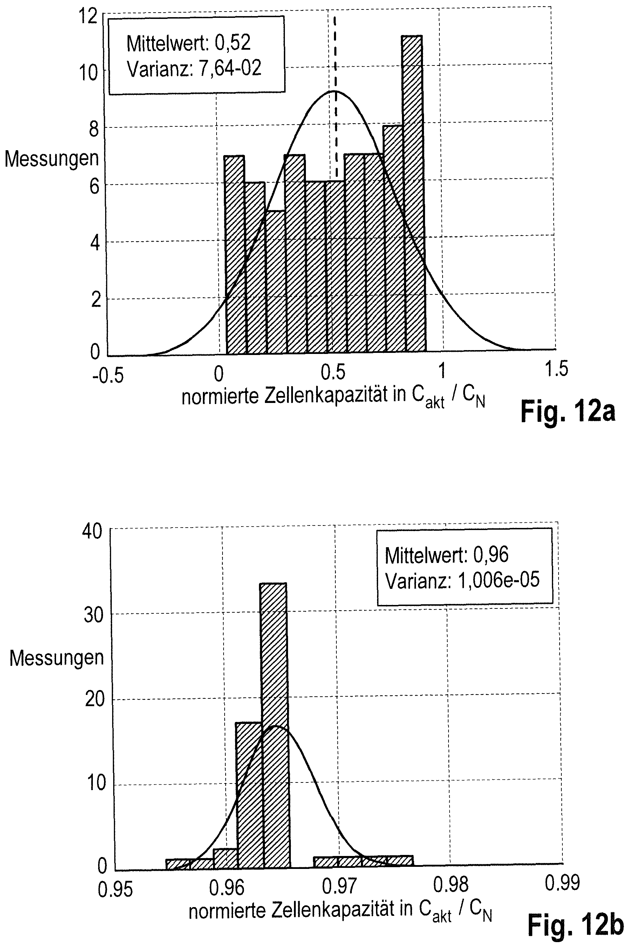

In den Abbildungen 12A bis 12D sind verschiedene Histogramme für verschiedene typische Lithium-Ionen-Zellchemien dargestellt.

Die Figuren 12A bis 12D zeigen eine Varianz der Änderung der Zellenkapazität bezüglich des Klemmenstromes $I_{KL}$ in vier charakteristischen Lithium-Ionen-Zellchemien.

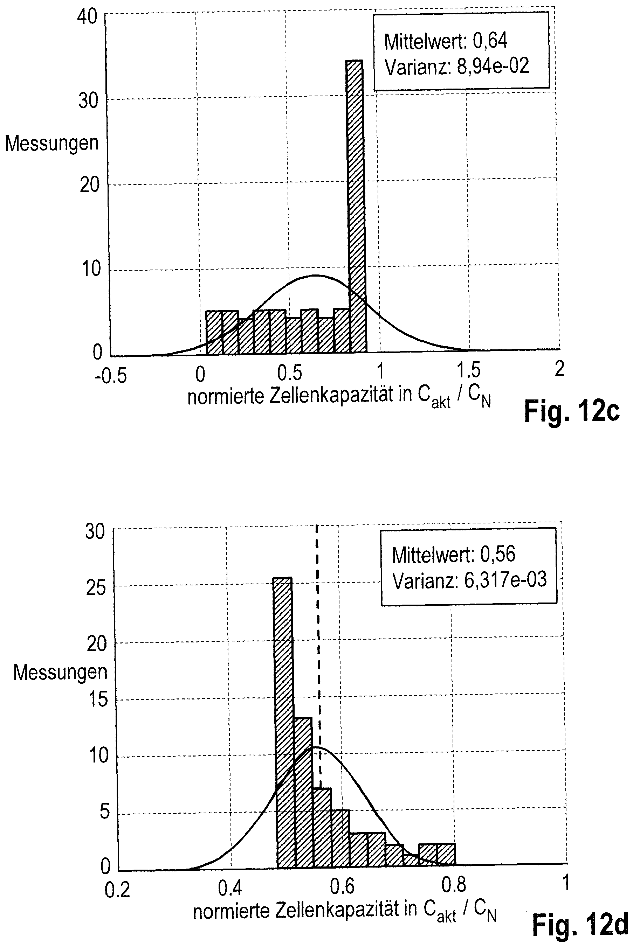

Fig. 12A zeigt eine Kapazitätsvarianz bei einer NMC-Batterie. Fig. 12B zeigt eine Kapazitätsvarianz bei einer LFP-Batterie. Fig. 12C zeigt eine Kapazitätsvarianz bei einer NCA-Batterie und Fig. 12D zeigt eine Kapazitätsvarianz bei einer LTO-Batterie.

Da die Varianz in Abhängigkeit des Klemmenstromes $I_{KL}$ als Vielfaches der ursprünglichen Zellenkapazität nach der Herstellung C0 vorliegt, kann die Differenz des Klemmenstromes für den Zykluszeitraum verwendet werden:

$$r_1 = (\frac{I_{KL}(t_2)}{C_0} - \frac{I_{KL}(t_1)}{C_0})\sigma_{C_n}$$

$$(11)$$

Die diskrete Rauschmodellierung folgt zu:

$$r_{1_k} = (\frac{u_k}{C_0} - \frac{u_{k-1}}{C_0})\sigma_{C_n}$$

$$(12)$$

Aus den Abbildungen 10A bis 10D ist ersichtlich, dass sich die beiden Zellchemien NCA und NMC kaum unterscheiden und die LFP- und die LTO-Chemie starke Schwankungen aufweist. Eine LFP-Batteriezelle zeigt das geringste Rauschverhalten. Dies bedeutet, dass sich die Zellenkapazität der Batteriezelle BZ bei Verwendung dieser Zellchemie viel schwächer ändert als bei anderen Zellchemien. Dazwischen liegt die LTO-Batteriezellenchemie. Für die Anpassung des Filters an die jeweilige Applikation kann die Zellchemie ausgewählt und dessen Rauschverhalten entsprechend berücksichtigt werden.

Bei einer bevorzugten Ausführungsform der erfindungsgemäßen Vorrichtung 1 und des erfindungsgemäßen Verfahrens erfolgt zusätzlich eine Stabilitätsüberwachung des dualen Kalman-Filters 2. Dies geschieht vorzugsweise anhand eines Kovarianzverhaltens der Batteriezellenzustände BZZ und eines Kovarianzverhaltens der Batteriezellenparameter BZP. Diese Stabilitätsanalyse basiert auf der Tatsache, dass bei einer drohenden Instabilität die Kovarianz des entsprechenden Batteriezellenzustandes BZZ oder Batteriezellenparameters BZP steigt, obwohl diese unter der gegebenen Filteranregung eigentlich sinken müsste. Dies geschieht lange bevor der jeweilige Wert des Batteriezellenzustandes BZZ oder Batteriezellenparameters BZP einen nicht-plausiblen Wert annimmt.

Um aus dem Verhalten der Kovarianz jedes Batteriezellenzustandes BZZ und jedes Batteriezellenparameters BZP abzuleiten, ob ggf. eine fehlerhafte Anpassung bzw. ein Fehlerfall vorliegt, der zu einer Instabilität des dualen Kalman-Filters 2 führen könnte, wird das korrekte Verhalten der Kovarianz untersucht. Dabei werden vorzugsweise die Diagonaleinträge einer Kovarianz-Matrix der Batteriezellenzustände BZZ und der Batteriezellenparameter BZP herangezogen, da diese die Autokorrelation des Schätzfehlers eines jeden Batteriezellenzustandes BZZ bzw. Batteriezellenparameters BZP darstellen. Die einzelnen Einträge stellen ein Maß für die Güte der aktuellen Schätzung dar. Je kleiner die Einträge bzw. die Diagonaleinträge der Kovarianzmatrix sind, desto genauer ist die aktuelle Schätzung des dualen Kalman-Filters 2. Zur Bewertung der Einträge wird eine Referenzgröße verwendet. Deren absoluter Betrag stellt keine Aussage über die korrekte Funktionsweise des dualen Kalman-Filters 2 dar. Vielmehr ist die Veränderung dieser Referenzgröße im Vergleich zu vorangegangenen Werten ein Maß für die korrekte Arbeitsweise, d.h. sinkt die Kovarianz, so wird der Fehler in der Schätzung geringer, wohingegen, falls die Kovarianz steigt, steigt höchstwahrscheinlich auch der Fehler in der Schätzung.

Um das generelle Verhalten der Kovarianz zu untersuchen bzw. zu analysieren, wird vorzugsweise zuerst dessen Verlauf basierend auf einem linearen Kalman-Filter untersucht. Für die zeitlich variablen Matrizen A, B, C sowie für die Rauschterme können hierzu konstante Werte angenommen werden. Die Kovarianz P hängt zudem nicht von den Eingängen des dualen Kalman-Filters 2 ab, womit der Verlauf dieser unabhängig von den Eingangsgrößen durchgeführt werden kann.

In Fig. 13 ist der Verlauf der beiden Diagonalwerte der Kovarianzmatrix P dargestellt. Fig. 13 zeigt den theoretischen Verlauf der Kovarianz der beiden Batteriezellenzustände $U_d$, SOC, d.h. der Diffusionsspannung und des Ladezustandes der Batteriezelle BZ. Fig. 13 zeigt den zeitlichen Verlauf einer Kovarianz für diese beiden Batteriezellenzustände BZZ.

Wie man aus Fig. 13 erkennen kann, fallen die beiden Kovarianzwerte exponentiell ab und nähern sich asymptotisch einem Endwert an. Dieser Endwert hängt von den Rauschkomponenten n, v ab.

Eine Erhöhung des Messrauschens n führt zu einer geringfügigen Erhöhung des Grenzwertes, d.h. zu einem flachen Verlauf.Eine Erhöhung des Prozessrauschens v führt zu einer direkten Erhöhung des Grenzwertes sowie zu einer leichten Veränderung des Verlaufs.

Basierend auf diesen Untersuchungen wird für jeden Batteriezellenzustand BZZ und für jeden Batteriezellenparameter BZP ein an das Kovarianzverhalten angepasster Trichter in Exponentialform definiert. Sofern eine Dynamik im System vorliegt, muss sich die jeweilige Kovarianz P innerhalb des vorgegebenen Trichters befinden. Sobald die Kovarianz P bei ausreichender Anregung den Trichter verlässt bzw. den Wert der Trichterfunktion überschreitet, kann eine drohende Instabilität des dualen Kalman-Filters 2 detektiert werden. Daraufhin wird die Anpassung des jeweiligen Batteriezellenzustandes BZZ bzw. Batteriezellenparameters BZP durch das duale Kalman-Filter 2 vorzugsweise ausgesetzt.

Der Verlauf der Kovarianz P innerhalb der Trichterfunktion TF ist beispielsweise in Fig. 14 dargestellt. Fig. 14 zeigt den Verlauf der Diffusionsspannung $U_D$ als Batteriezellenzustand BZZ innerhalb bzw. unterhalb der Trichterfunktion TF(t). Es muss sichergestellt sein, dass ein ausreichender Abstand zwischen dem Verlauf der Trichterfunktion und dem korrekten Kovarianzverlauf vorhanden ist. Bei einer bevorzugten Ausführungsform ist die Trichterfunktion TF eine exponentiell abfallende Trichterfunktion mit konfigurierbaren Koeffizienten a, b, c.

Die Trichterfunktion TF(t) weist bei einer möglichen Ausführungsform die folgende Form auf:

$$TF(t) = a \cdot e^{b \cdot t} + c \ ,$$

wobei die Koeffizienten a, b die Steigung der Kurve und der Koeffizient c den endgültigen Grenzwert der Funktion bestimmen, wobei b < 0, a > 0 und c > 0. Da es sich bei dem dualen Kalman-Filter 2 um ein nichtlineares dynamisches System handelt, bei dem selbst die einzelnen Rauschterme von bestimmten Einflussfaktoren abhängen, wird die Form des Trichters bzw. der Trichterfunktion TF vorzugsweise anhand der realen Reaktion der einzelnen Batteriezellenzustände BZZ und Batteriezellenparameter BZP angepasst.

Mit dem erfindungsgemäßen Verfahren und der erfindungsgemäßen Vorrichtung 1 ist es möglich, Batteriezellenparameter BZP der Batteriezelle BZ dynamisch mit den Batteriezellenzuständen BZZ zu schätzen. Weiterhin erlaubt das erfindungsgemäße Verfahren die aktuelle Batteriekapazität zu schätzen und in der Berechnung des Ladezustandes SOC mit zu berücksichtigen. Weiterhin erlaubt das erfindungsgemäße Verfahren den Ladezustand SOC basierend auf der aktuellen Batteriekapazität zu schätzen und nicht wie bisher fälschlicherweise üblich, über die Nennkapazität C0, welches in dem Datenblatt der Batteriezelle angegeben ist. Weiterhin ermöglicht das erfindungsgemäße Verfahren und die erfindungsgemäße Vorrichtung 1, anhand der charakteristischen Parametereinflüsse der jeweiligen Zellchemie das Rauschverhalten vorzugeben. Hierbei muss nicht über ein Filtertuning nachgeregelt werden. Es ist ferner möglich, auch nur die jeweilige Zellenchemie zu berücksichtigen, wobei die Vermessung nicht für verschiedene Batteriezellen separat durchgeführt werden muss.

Weiterhin ermöglicht das erfindungsgemäße Stabilitätsüberwachungsverfahren, eine drohende Instabilität jedes Batteriezellenzustandes BZZ und/oder jeden Batteriezellenparameters BZP frühzeitig zu erkennen. Damit ist es möglich, die Schätzung des jeweiligen Batteriezellenzustandes BZZ und Batteriezellenparameters BZP auszusetzen, bis die detektierte Instabilität behoben wird. Hierdurch kann ein stabiler Betrieb des dualen Kalman-Filters 2 gewährleistet werden. Weiterhin ist es möglich, das duale Kalman-Filter 2 als adaptives Filter auch in Batterie-Management-Systemen BMS einzusetzen.

Das Filtertuning des dualen Kalman-Filters 2 erfolgt bei dem erfindungsgemäßen Verfahren mithilfe messbarer Rauschkomponenten. Dies erlaubt eine schnelle Anpassung des dualen Kalman-Filters 2 an verschiedene neue Batteriesysteme bzw. Batteriezellen BZ. Die jeweiligen Einflussgrößen können exakt kontrolliert werden.

Das erfindungsgemäße Verfahren erlaubt mit einer sehr hohen Präzision eine Ladezustandsbestimmung einer Batteriezelle BZ bzw. einer Batterie. Wird diese Batteriezelle BZ beispielsweise zum Antrieb eines Elektromotors eines Fahrzeuges benutzt, wird hierdurch die Reichweitenprognose für das Fahrzeug signifikant verbessert.

Das erfindungsgemäße Detektionsverfahren arbeitet robust und zuverlässig. Es ist flexibel für verschiedene Systeme von Batteriezellentypen anpassbar. Das erfindungsgemäße Verfahren kann mithilfe eines dualen Kalman-Filters 2 mit relativ geringem technischem Aufwand implementiert werden. Bei einer möglichen Ausführungsvariante können die erfindungsgemäße Detektionsvorrichtung 1 im Gehäuse einer Batterie, welche eine oder mehrere Batteriezellen BZ umfasst, integriert werden, um Batteriezellenzustände BZZ und/oder Batteriezellenparameter BZP der Batteriezelle BZ zu detektieren. Die detektierten Batteriezellenzustände BZZ und/oder detektierten Batteriezellenparameter BZP können an eine Steuereinheit übermittelt werden. Diese Steuereinheit kann in Abhängigkeit der detektierten Batteriezellenparameter BZP und detektierten Batteriezellenzustände BZZ eine Stromquelle zum Aufladen der Batteriezelle und/oder eine durch die Batteriezelle betriebene elektrische Last ansteuern. Das erfindungsgemäße Detektionsverfahren kann in Echtzeit ausgeführt werden. Die in Echtzeit detektierten Batteriezellenzustände BZZ und/oder Batteriezellenparameter BZP können in Echtzeit ausgewertet werden und zu Regelungs- bzw. Steuervorgängen, beispielsweise in einem Elektromotor oder einer Photovoltaikanlage, herangezogen werden. Bei einer bevorzugten Ausführungsform verfügt die erfindungsgemäße Detektionsvorrichtung 1 über eine integrierte Stabilitätsüberwachung und wird bei drohender Instabilität automatisch deaktiviert.

Die Erfindung schafft gemäß einem weiteren Aspekt ein Batterie-Management-System BMS für eine Batterie, welche aus einer oder mehreren Batteriezellen besteht, mit einer erfindungsgemäßen Detektionsvorrichtung 1 zur Detektion von Batteriezellenzuständen BZZ und/oder Batteriezellenparametern BZP.

Gemäß einem weiteren Aspekt schafft die Erfindung ein Elektrofahrzeug mit einem derartigen Batterie-Management-System und einer oder mehreren Batteriezellen BZ.

Gemäß einem weiteren Aspekt schafft die Erfindung eine Photovoltaikanlage mit aufladbaren Batteriezellen BZ und einem Batterie-Management-System BMS, welche eine erfindungsgemäße Detektionsvorrichtung 1 besitzt.

Das erfindungsgemäße Verfahren und die erfindungsgemäße Vorrichtung 1 zur Detektion von Batteriezellenzuständen BZZ und/oder Batteriezellenparametern BZP ist vielseitig einsetzbar und kann bei beliebigen aufladbaren Batteriezellen BZ bzw. Energiespeichern verwendet werden.

**Patentansprüche**

1. Verfahren zum Detektieren von Batteriezellenzuständen, BZZ, und von Batteriezellenparametern, BZP, mindestens einer Batteriezelle (BZ) mit den folgenden Schritten:

   (a) Ermitteln (S1) von Rauschanteilen (n, v) eines Zustandsschätzers (2A) eines dualen Kalman-Filters (2) und Ermitteln von Rauschanteilen eines Parameterschätzers (2B) des dualen Kalman-Filters (2) anhand eines charakteristischen Parameterverhaltens der Batteriezelle (BZ) bezüglich mindestens einer Batteriezellenkenngröße, BZK, der Batteriezelle (BZ); und

(b) Anpassen (S2) der Batteriezellenzustände, BZZ, und der Batteriezellenparameter, BZP, an ein vorgegebenes Batteriemodell (BM) der Batteriezelle (BZ) durch das duale Kalman-Filter (2) auf Basis der ermittelten Rauschanteile (n, v).

2. Verfahren nach Anspruch 1,
   wobei die Batteriezellenzustände, BZZ,
   einen Ladezustand, SoC, der Batteriezelle (BZ) und/oder dynamische Batteriezellenzustände, insbesondere eine Diffusionsspannung, $U_d$, der Batteriezelle (BZ) aufweisen, wobei die Batteriezellenparameter, BZP,
   einen Innenwiderstand, $R_i$, der Batteriezelle (BZ),
   eine Nennkapazität, $C_n$, der Batteriezelle (BZ), und/oder resistive Dynamikkomponenten, insbesondere einen Diffusionswiderstand, $R_d$, der Batteriezelle (BZ) und/oder kapazitive Dynamikkomponenten, insbesondere
   eine Diffusionskapazität, $C_D$, der Batteriezelle (BZ) aufweisen, und
   wobei die Batteriezellenkenngrößen, BZK,
   eine Belastungskenngröße der Batteriezelle (BZ),
   eine Temperatur, T, der Batteriezelle (BZ) und/oder
   eine Alterungskenngröße der Batteriezelle (BZ) aufweisen.

3. Verfahren nach Anspruch 1 oder 2,
   wobei die ermittelten Rauschanteile (n, v) ein Prozessrauschen (v) und/oder ein Messrauschen (n) aufweisen,
   wobei das Prozessrauschen (v) ein Prozessrauschen ($v_{BZZ}$) der Batteriezellenzustände, BZZ, und/oder ein Prozessrauschen ($v_{BZP}$) der Batteriezellenparameter, BZP, umfasst.

4. Verfahren nach einem der vorangehenden Ansprüche 1 bis 3,
   wobei ein Zustandsvektor des Zustandsschätzers (2A) des dualen Kalman-Filters (2) die Batteriezellenzustände ($x_{BZZ}$) der Batteriezelle (BZ) und ein Zustandsvektor des Parameterschätzers (2B) des dualen Kalman-Filters (2) die Batteriezellenparameter ($x_{BZP}$) der Batteriezelle (BZ) aufweist.

5. Verfahren nach einem der vorangehenden Ansprüche 1 bis 4,
   wobei eine Belastung der Batteriezelle (BZ) anhand der detektierten Batteriezellenzustände, BZZ, und der detektierten Batteriezellenparameter, BZP, gesteuert wird.

6. Verfahren nach einem der vorangehenden Ansprüche,
   wobei die durch den Zustandsschätzer (2A) des dualen Kalman-Filters (2) angepassten Batteriezellenzustände, BZZ, der Batteriezelle (BZ) und die durch den Parameterschätzer (2B) des dualen Kalman-Filters (2) angepassten Batteriezellenparameter, BZP, der Batteriezelle (BZ) an eine Steuereinheit (5) zur Steuerung einer an der Batteriezelle (BZ) angeschlossenen Last (6), insbesondere eines Elektromotors, und/oder zur Steuerung einer an der Batteriezelle (BZ) angeschlossenen Stromquelle (7), ausgegeben werden.

7. Verfahren nach einem der vorangehenden Ansprüche,
   wobei das charakteristische Parameterverhalten der Batteriezelle (BZ) für jeden Batteriezellenparameter, BZP, dessen Mittelwert, $\mu_{BZP}$, und/oder dessen Varianz, $\sigma_{BZP}$, bezogen auf jeden Batteriezellenzustand, BZZ, und/oder auf Basis sensorisch erfasster Messgrößen, MG, der Batteriezelle (BZ) angibt,
   wobei das gespeicherte charakteristische Parameterverhalten der Batteriezelle (BZ) auf Basis sensorisch erfasster Messgrößen, MG, welche einen Klemmenstrom ($I_{KL}$), eine Klemmenspannung ($U_{KL}$) und/oder eine Temperatur (T) der Batteriezelle (BZ) umfassen, bestimmt wird.

8. Verfahren nach einem der vorangehenden Ansprüche,
   wobei ein Prozessrauschen ($v_{BZP}$) eines Batteriezellenparameters, BZP, in Abhängigkeit von dessen ausgelesenen charakteristischen Parameterverhalten bezogen auf einen Batteriezellenzustand, BZZ, und/oder auf Basis sensorisch erfasster Messgrößen, MG, und in Abhängigkeit einer zeitlichen Änderung dieses Batteriezellenzustandes, BZZ, und/oder auf Basis sensorisch erfasster Messgrößen, MG, ermittelt wird, wobei ein Prozessrauschen ($v_{BZZ}$) eines Batteriezellenzustandes, BZZ, in Abhängigkeit von dessen ausgelesenen Parameterverhalten bezogen auf mindestens einen Batteriezellenparameter, BZP, ermittelt wird.

9. Verfahren nach einem der vorangehenden Ansprüche,

wobei für jede sensorisch erfasste Messgröße, MG, dessen Messgrößenrauschen auf Basis von einem Mittelwert, $\mu_{MG}$, und/oder einer Varianz, $\sigma_{MG}$, eines Rauschverhaltens des entsprechenden Messgrößensensors bezogen auf die Messgröße, MG, die aus einem Datenspeicher (4) ausgelesen werden, berechnet wird,wobei das berechnete Messgrößenrauschen aller Messgrößen, MG, zur Ermittlung des Messrauschens (n) addiert werden.

10. Verfahren nach einem der vorangehenden Ansprüche,
    wobei eine Stabilität des dualen Kalman-Filters (2) überwacht und das Anpassen der jeweiligen Batteriezellenzustände, BZZ, durch den Zustandsschätzer (2A) des dualen Kalman-Filters (2) und der jeweiligen Batteriezellenparameter, BZP, durch den Parameterschätzer (2B) des dualen Kalman-Filters (2) ausgesetzt wird, sobald eine drohende Instabilität des dualen Kalman-Filters (2) erkannt wird,wobei die Stabilitätsüberwachung des dualen Kalman-Filters (2) anhand eines Kovarianzverhaltens ($P_{BZZ}$) der Batteriezellenzustände, BZZ, und eines Kovarianzverhaltens ($P_{BZP}$) der Batteriezellenparameter, BZP, erfolgt.

11. Verfahren nach einem der vorangehenden Ansprüche,
    wobei das Kovarianzverhalten ($P_{BZZ}$) eines Batteriezellenzustandes, BZZ, und/oder das Kovarianzverhalten ($P_{BZP}$) eines Batteriezellenparameters, BZP, des dualen Kalman-Filters (2) mit einem zugehörigen gespeicherten Soll-Kovarianzverhalten verglichen wird,wobei das Anpassen eines Batteriezellenzustandes, BZZ, durch den Zustandsschätzer (2A) des dualen Kalman-Filters (2) ausgesetzt wird, sobald dessen Kovarianzverhalten ($P_{BZZ}$) das gespeicherte zugehörige Soll-Kovarianzverhalten des jeweiligen Batteriezellenzustandes, BZZ, überschreitet, und
    wobei das Anpassen eines Batteriezellenparameters, BZP, durch den Parameterschätzer (2B) des dualen Kalman-Filters (2) ausgesetzt wird, sobald dessen Kovarianzverhalten ($P_{BZP}$) das gespeicherte zugehörige Soll-Kovarianzverhalten des jeweiligen Batteriezellenparameters, BZP, überschreitet,wobei das gespeicherte Soll-Kovarianzverhalten eine exponentiell über die Zeit abfallende Trichterfunktion (TF(t)) aufweist, deren Koeffizienten (a,b,c) konfiguriert werden.

12. Vorrichtung (1) zur Detektion von Batteriezellenzuständen, BZZ, und/oder Batteriezellenparametern, BZP, mindestens einer Batteriezelle (BZ) mit:

    - einem dualen Kalman-Filter (2), der einen Zustandsschätzer (2A) zur Schätzung von Batteriezellenzuständen, BZZ, und einen Parameterschätzer (2B) zur Schätzung von Batteriezellenparametern, BZP, aufweist, und mit
    - einer Ermittlungseinheit (3), die geeignet ist, Rauschanteile (n, v) des Zustandsschätzers (2A) und des Parameterschätzers (2B) anhand eines gespeicherten charakteristischen Parameterverhaltens der Batteriezelle (BZ) zu ermitteln,
    wobei die Batteriezellenzustände, BZZ, und die Batteriezellenparameter, BZP, an ein vorgegebenes Batteriemodell (BM) der Batteriezelle (BZ) durch das duale Kalman-Filter (2) auf Basis der durch die Ermittlungseinheit ermittelten Rauschanteile (n, v) automatisch anpassbar sind.

13. Vorrichtung nach Anspruch 12,
    wobei der Zustandsschätzer (2A) des dualen Kalman-Filters (2) durch ein erstes Kalman-Filter und der Parameterschätzer (2B) des dualen Kalman-Filters (2) durch ein zweites Kalman-Filter gebildet ist.

14. Vorrichtung nach Anspruch 13,
    wobei die beiden Kalman-Filter (2A, 2B) des dualen Kalman-Filters (2) jeweils ein Lineares Kalman-Filter (LKF) Extended Kalman-Filter (EKF), ein Unscented Kalman-Filter (UKF), ein Square-Root Unscented Kalman-Filter (SR-UKF) oder ein Central-Difference-Kalman-Filter (CD-KF) aufweisen.

15. Vorrichtung nach einem der vorangehenden Ansprüche 12 bis 14,
    wobei die durch den Zustandsschätzer (2A) des dualen Kalman-Filters (2) angepassten Batteriezellenzustände, BZZ, und die durch den Parameterschätzer (2B) des dualen Kalman-Filters (2) angepassten Batteriezellenparameter, BZP, der Batteriezelle (BZ) an eine Steuereinheit (5) ausgegeben werden, welche zur Steuerung einer an der Batteriezelle (BZ) angeschlossenen Last (6), insbesondere eines Elektromotors, und/oder zur Steuerung einer an der Batteriezelle (BZ) angeschlossenen Stromquelle (7), vorgesehen ist.

Fig. 1

Fig. 2

Fig. 3

CRTL-SQ

SE

CRTL

5

DKF

2A

2B

2

ON / OFF

n, V

BZZ

3

4

14

13

$U_{KL}$

$I_{KL}$

$T_{BZ}$

CRTL-$R_L$

SQ

7

8

$U_{KL}$

9

10

11

$R_L$

6

BZ

$\oplus$

$\ominus$

T

12

1

Fig. 4

2

2A

$\Sigma^+_{\tilde{x},\,k-1}$

$\hat{x}^+_{k-1}$

$u_{k-1}$

PT

$\Sigma^-_{\tilde{x},\,k}$

KT

$\hat{x}^+_k$

$\hat{\theta}^-_k$   $\hat{x}^-_k$   $u_k$   $y_k$

2B

$\hat{\theta}^+_{k-1}$

PT

$\Sigma^-_{\tilde{\theta},\,k}$

$\Sigma^+_{\tilde{\theta},\,k-1}$

KT

$\hat{\theta}^+_k$

**Fig. 5**

$R_{DC,1S}$

$C_D$

$I_{KL}$

$U_0\,(SOC)$

$R_D$

$U_{KL}$

$U_D$

**Fig. 6**

Fig. 7a

Fig. 7b

Fig. 8a

Mittelwert: 4,01 V
Varianz: 5,546e-05

Fig. 8b

Fig. 9a

Fig. 9b

Fig. 9c

Fig. 9d

Fig. 10a

Fig. 10b

Fig. 10c

Fig. 10d

Mittelwert: 0,04
Varianz: 1,29e-04

$R_{DC, 1S}$ in $\Omega$

**Fig. 11a**

Mittelwert: 110 s
Varianz: 5,57e+02

$\tau_{RC}$ in s

**Fig. 11b**

Mittelwert: 0,12
Varianz: 1,64e-02

**Fig. 11c**

Mittelwert: 1459 F
Varianz: 2,32e+05

**Fig. 11d**

Mittelwert: 0,52
Varianz: 7,64-02

normierte Zellenkapazität in $C_{akt}$ / $C_N$

**Fig. 12a**

Mittelwert: 0,96
Varianz: 1,006e-05

normierte Zellenkapazität in $C_{akt}$ / $C_N$

**Fig. 12b**

Fig. 12c

Fig. 12d

Fig. 13

Fig. 14

EP 3 435 102 A1

**Europäisches Patentamt**
**European Patent Office**
**Office européen des brevets**

# EUROPÄISCHER RECHERCHENBERICHT

Nummer der Anmeldung

EP 17 18 3316

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | GEORG WALDER ET AL: "Adaptive State and Parameter Estimation of Lithium-Ion Batteries Based on a Dual Linear Kalman Filter", CONFERENCE ON FUTURE AUTOMOBILE TECHNOLOGY, 1. Januar 2014 (2014-01-01), Seiten 16-24, XP055438553, ISBN: 978-0-989-13054-7 | 1-9, 12-15 | INV. G01R31/36 ADD. G06F17/18 H03H17/02 |
| Y | * Seite 17, Spalte 2 - Seite 22, Spalte 1; Abbildungen 2-5 * ----- | 10,11 | |
| X | Christian Campestrini ET AL: "Temperature Influences on State and Parameter Estimation Based on a Dual Kalman Filter", 3. Conference on Future Automobile Technology, 15. März 2014 (2014-03-15), XP055438697, Gefunden im Internet: URL:http://mediatum.ub.tum.de/doc/1226678/file.pdf [gefunden am 2018-01-08] * Seite 1, Spalte 1 - Seite 3, Spalte 1; Abbildungen 1,3,9,12-14 * * Seite 5 - Seite 6 * ----- | 1,12 | |
| A | US 2016/116542 A1 (BABA ATSUSHI [JP] ET AL) 28. April 2016 (2016-04-28) * das ganze Dokument * ----- | 1-15 | RECHERCHIERTE SACHGEBIETE (IPC) G01R G06F H03H |
| Y | EP 1 231 475 A2 (BOSCH GMBH ROBERT [DE]) 14. August 2002 (2002-08-14) * Absätze [0001], [0002], [0009] - Absatz [0012]; Abbildungen 1a,1b,2b,4,5 * * Absatz [0021] - Absatz [0026] * * Absatz [0032] - Absatz [0036] * ----- | 10,11 | |
| | -/-- | | |

Der vorliegende Recherchenbericht wurde für alle Patentansprüche erstellt

| Recherchenort | Abschlußdatum der Recherche | Prüfer |
|---|---|---|
| München | 9. Januar 2018 | Hof, Klaus-Dieter |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Seite 1 von 2

**Europäisches Patentamt**

**European Patent Office**

**Office européen des brevets**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | Eric A. Wan ET AL: "Dual Extended Kalman Filter Methods" In: "Kalman Filtering and Neural Networks", 1. Oktober 2001 (2001-10-01), John Wiley & Sons, Inc., New York, USA, XP055439123, ISBN: 978-0-471-36998-1 Seiten 123-173, DOI: 10.1002/0471221546.ch5, * das ganze Dokument * ----- | 1-15 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| München | 9. Januar 2018 | Hof, Klaus-Dieter |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
......................................................................
& : Mitglied der gleichen Patentfamilie, übereinstimmendes Dokument

EPO FORM 1503 03.82 (P04C03)

Seite 2 von 2

**ANHANG ZUM EUROPÄISCHEN RECHERCHENBERICHT
ÜBER DIE EUROPÄISCHE PATENTANMELDUNG NR.**

EP 17 18 3316

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-01-2018

| Im Recherchenbericht angeführtes Patentdokument | Datum der Veröffentlichung | Mitglied(er) der Patentfamilie | Datum der Veröffentlichung |
|---|---|---|---|
| US 2016116542 A1 | 28-04-2016 | CN 105378496 A<br>JP 6130275 B2<br>JP 2015052483 A<br>US 2016116542 A1<br>WO 2015033503 A1 | 02-03-2016<br>17-05-2017<br>19-03-2015<br>28-04-2016<br>12-03-2015 |
| EP 1231475 A2 | 14-08-2002 | DE 10106505 A1<br>EP 1231475 A2<br>ES 2280293 T3<br>US 2002169581 A1 | 29-08-2002<br>14-08-2002<br>16-09-2007<br>14-11-2002 |

Für nähere Einzelheiten zu diesem Anhang : siehe Amtsblatt des Europäischen Patentamts, Nr.12/82